# EUROPÄISCHE PATENTSCHRIFT

(11) **EP 2 489 084 B1**
(45) Veröffentlichungstag und Bekanntmachung des Hinweises auf die Patenterteilung: **23.12.2015**
(21) Anmeldenummer: 10768912.7
(22) Anmeldetag: 11.10.2010
(51) Int. Cl.: H01L 51/42

(54) **MISCHUNGEN ZUR HERSTELLUNG VON PHOTOAKTIVEN SCHICHTEN FÜR ORGANISCHE SOLARZELLEN UND ORGANISCHE PHOTODETEKTOREN**
COMPOSITIONS FOR THE PRODUCTION OF PHOTOACTIVE LAYERS FOR ORGANIC SOLAR CELLS AND ORGANIC PHOTO DETECTORS
COMPOSITIONS POUR LA PRODUCTION DES COUCHES PHOTOACTIVES POUR DES CELLULES SOLAIRES ORGANIQUES ET DES PHOTODETECTEURS

(30) Priorität: 13.10.2009 EP 09172939
(43) Veröffentlichungstag der Anmeldung: 22.08.2012
(73) Patentinhaber: BASF SE, 67056 Ludwigshafen (DE)
(72) Erfinder: REICHELT, Helmut, 67435 Neustadt (DE); WÜRTHNER, Frank, 97204 Höchberg (DE); BUERCKSTUEMMER, Hannah, 97078 Wuerzburg (DE); TULYAKOVA, Elena, 59000-Cedex Lille (DE); HWANG, Jae Hyung, 68519 Viernheim (DE); ERK, Peter, 67227 Frankenthal (DE); SENS, Rüdiger, 67069 Ludwigshafen (DE); BRUDER, Ingmar, 67376 Harthausen (DE); OJALA, Antti, 67063 Ludwigshafen (DE); SCHÖNEBOOM, Jan, 68199 Mannheim (DE); STEINMANN, Vera, 59071 Hamm (DE); KRONENBERG, Nils, 50674 Köln (DE); MEERHOLZ, Klaus, 51503 Rösrath (DE)
(86) Internationale Anmeldenummer: PCT/EP2010/065152
(87) Internationale Veröffentlichungsnummer: WO 2011/045253

(56) Entgegenhaltungen:
- EP-A1- 0 509 302
- EP-A2- 0 416 434
- WO-A1-2009/007340
- US-A- 6 086 637
- US-A1- 2003 152 827

## Beschreibung

Die vorliegende Erfindung betrifft die Verwendung von Mischungen, enthaltend als Komponenten
K1) eine oder mehrere Verbindungen ausgewählt aus der Gruppe der Verbindungen der allgemeinen Formel 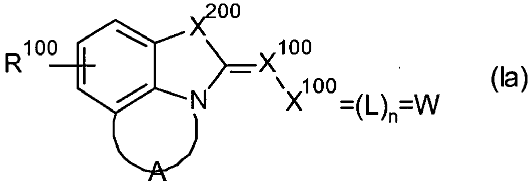 als Elektronendonor bzw. Elektronenakzeptor, worin bedeuten
   - A: eine Brücke bestehend aus zwei oder drei sp³-hybridisierten Kohlenstoffatomen, in welcher jedes Kohlenstoffatom zusätzlich noch mit je einem Substituenten R¹⁰¹ substituiert oder welche benzanelliert sein kann,
   - W: C(CN)₂,
   - L: ein zweiwertiger, gegebenenfalls ein- oder mehrfach anellierter Carbo- oder Heterocyclus,
   - n: 1,
   - X¹⁰⁰: CH,
   - X²⁰⁰: C(R¹¹¹)₂,
   - R¹⁰⁰: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, OR¹¹⁰, SR¹¹⁰, Hetaryl, Halogen, NO₂ oder CN,
   - R¹⁰¹: Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl oder Hetaryl,
   - R¹¹⁰: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl oder Aryl,
   - R¹¹¹: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl oder Hetaryl,
   wobei die Kohlenstoffketten der Alkyl- und Cylcloalkyl-Reste durch ein oder zwei nichtbenachbarte Sauerstoffatome unterbrochen sein können, und die zuvor genannten Variablen, sofern sie mehr als einmal auftreten, gleich oder voneinander verschieden sein können
   und
K2) eine oder mehrere Verbindungen, welche gegenüber Komponente K1) entsprechend als Elektronenakzeptor bzw. Elektronendonor wirken,
zur Herstellung von photoaktiven Schichten für organische Solarzellen und organische Photodetektoren, ein Verfahren zur Herstellung von photoaktiven Schichten, entsprechende organische Solarzellen und organische Photodetektoren, sowie Mischungen, welche als Komponenten ein oder mehrere Verbindungen der allgemeinen Formel la der Komponente K1 und ein oder mehrere Verbindungen der Komponente K2 enthalten.

Es wird erwartet, dass zukünftig in vielen Bereichen der Elektronikindustrie neben den klassischen anorganischen Halbleitern zunehmend auch organische Halbleiter auf Basis von niedermolekularen oder polymeren Materialien eingesetzt werden. Diese weisen vielfach Vorteile gegenüber den klassischen anorganischen Halbleitern auf, beispielsweise eine bessere Substratkompatibilität und eine bessere Verarbeitbarkeit der auf ihnen basierenden Halbleiterbauteile. Sie erlauben die Verarbeitung auf flexiblen Substraten und ermöglichen es, ihre Grenzorbitalenergien mit den Methoden des Molecular Modellings auf den jeweiligen Anwendungsbereich genau anzupassen. Die deutlich verringerten Kosten derartiger Bauteile haben dem Forschungsgebiet der organischen Elektronik eine Renaissance gebracht. Die "Organische Elektronik" beschäftigt sich schwerpunktmäßig mit der Entwicklung neuer Materialien und Fertigungsprozesse für die Herstellung elektronischer Bauelemente auf der Basis organischer Halbleiterschichten. Dazu zählen vor allem organische Feldeffekttransistoren (Organic Field-Effect Transistors, OFET) sowie organische Leuchtdioden (Organic Light Emitting Diodes, OLED; z.B. für den Einsatz in Displays) und die organische Photovoltaik.

Die Direktumwandlung von Solarenergie in elektrische Energie in Solarzellen beruht auf dem inneren Photoeffekt eines Halbleitermaterials, d.h. der Erzeugung von Elektron-Loch-Paaren durch Absorption von Photonen und der Trennung der negativen und positiven Ladungsträger an einem p-n-Übergang oder einem Schottky-Kontakt. Die so erzeugte Photospannung kann in einem äußeren Stromkreis einen Photostrom bewirken, durch den die Solarzelle ihre Leistung abgibt.

Vom Halbleiter können dabei nur solche Photonen absorbiert werden, die eine Energie aufweisen, die größer als seine Bandlücke ist. Die Größe der Halbleiterbandlücke bestimmt also den Anteil des Sonnenlichts, der in elektrische Energie umgewandelt werden kann. Es wird zukünftig erwartet, dass organische Solarzellen die klassischen Solarzellen auf Siliziumbasis aufgrund geringerer Kosten, eines geringeren Gewichts, der Möglichkeit zur Herstellung flexibler und/oder farbiger Zellen, der besseren Möglichkeit zur Feinabstimmung des Bandabstands übertreffen werden. Es besteht somit ein großer Bedarf an organischen Halbleitern, die sich zur Herstellung organischer Solarzellen eignen.

Um die Sonnenenergie möglichst effektiv zu nutzen bestehen organische Solarzellen normalerweise aus zwei absorbierenden Materialien mit unterschiedlicher Elektronenaffinität bzw. unterschiedlichem lonisationsverhalten. Das eine Material wirkt dann als p-Leiter (Elektronendonor), das andere als n-Leiter (Elektronenakzeptor). Die ersten organischen Solarzellen bestanden aus einem zweilagigen System aus einem KupferPhthalocyanin als p-Leiter und PTCBI als n-Leiter und zeigten einen Wirkungsgrad von 1 %. Um möglichst alle auftreffenden Photonen zu nutzen, werden relativ hohe Schichtdicken eingesetzt (z. B. 100 nm). Um Strom zu erzeugen, muss der durch die absorbierten Photonen erzeugte angeregte Zustand jedoch eine p-n-Grenzschicht ("p-n-junction") erreichen, um ein Loch und ein Elektron zu erzeugen, welches dann zur Anode und Kathode fließt. Die meisten organischen Halbleiter haben jedoch nur Diffusionslängen für den angeregten Zustand von bis zu 10 nm. Selbst durch die besten bisher bekannten Herstellverfahren kann die Distanz, über die der angeregte Zustand weitergeleitet werden muss, auf minimal 10 bis 30 nm verringert werden.

Neuere Entwicklungen in der organischen Photovoltaik gehen in die Richtung der sogenannten "Bulk-Heterojunction": die photoaktive Schicht enthält hierbei die Akzeptor- und Donorverbindung(en) als bikontinuierliche Phase. Durch photoinduzierten Ladungstransfer vom angeregten Zustand der Donorverbindung zur Akzeptorverbindung findet aufgrund der räumlichen Nähe der Verbindungen eine, verglichen mit anderen Relaxationsvorgängen, schnelle Ladungstrennung statt und die entstandenen Löcher und Elektronen werden über die entsprechende Elektroden abgeführt. Zwischen die Elektroden und die photoaktive Schicht werden oftmals weitere Schichten, wie z. B. Löcher- oder Elektronentransportschichten, aufgebracht, um die Effizienz solcher Zellen zu erhöhen.

Bislang werden als Donormaterialien in solchen Bulk-Heterojunction-Zellen meist Polymere, wie z. B. Polyvinylphenylene oder Polythiophene, oder Farbstoffe aus der Klasse der Phthalocyanine, z. B. Zn- oder Vanadylphthalocyanin, und als Akzeptormaterialien Fulleren und Fulleren-Derivate sowie verschiedene Perylene verwendet. Intensiv wurden und werden photoaktive Schichten aus den Donor-/Akzeptor-Paaren Poly(3-hexyl-thiophen) ("P3HT")/ [6,6]-Phenyl-C₆₁-butylsäuremethylester ("PCBM"), Poly(2-methoxy-5-(3,7-dimethyloctyloxy)-1,4-phenylenvinylen) ("OC₁C₁₀-PPV")/PCBM und Zn-Phthalocyanin/Fulleren untersucht.

Organische Solarzellen unter Verwendung von Merocyaninen werden in der Schrift WO 2009/007340 A1 beschrieben.

Aufgabe der vorliegenden Erfindung war es nun, weitere photoaktive Schichten zur Verwendung in elektronischen Bauelementen, insbesondere in organischen Solarzellen und organischen Photodetektoren, bereitzustellen, welche leicht herstellbar sind und für die Umwandlung von Lichtenergie in elektrische Energie in technischen Anwendungen einen ausreichenden Wirkungsgrad aufweisen.

Dementsprechend wurde die eingangs beschriebene Verwendung von Mischungen zur Herstellung von photoaktiven Schichten für organische Solarzellen und organische Photodetektoren gefunden.

Die Definitionen der vorstehend aufgeführten Variablen werden nachfolgend erläutert und sind wie nachfolgend zu verstehen.

Halogen bezeichnet Fluor, Chlor, Brom und Iod, insbesondere Fluor und Chlor.

Unter Alkyl sind substituierte oder unsubstituierte C₁-C₂₀-Alkylreste zu verstehen. Bevorzugt sind C₁- bis C₁₀-Alkylreste, besonders bevorzugt C₁- bis C₆-Alkylreste. Die Alkylreste können sowohl geradkettig als auch verzweigt sein. Des Weiteren können die Alkylreste mit einem oder mehreren Substituenten ausgewählt aus der Gruppe bestehend aus C₁-C₂₀-Alkoxy, Halogen, bevorzugt F, und C₆-C₃₀-Aryl, das wiederum substituiert oder unsubstituiert sein kann, substituiert sein. Geeignete Arylsubstituenten sowie geeignete Alkoxy- und Halogensubstituenten sind nachstehend genannt. Beispiele für geeignete Alkylgruppen sind Methyl, Ethyl, Propyl, Butyl, Pentyl, Hexyl, Heptyl und Octyl sowie mit C₆-C₃₀-Aryl-, C₁-C₂₀-Alkoxy- und/oder Halogen, insbesondere F, substituierte Derivate der genannten Alkylgruppen, zum Beispiel CF₃. Dabei sind sowohl die n-Isomere der genannten Reste als auch verzweigte Isomere wie Isopropyl, Isobutyl, Isopentyl, sek-Butyl, tert-Butyl, Neopentyl, 3,3-Dimethylbutyl, 3-Ethylhexyl usw. mit umfasst. Bevorzugte Alkylgruppen sind Methyl, Ethyl, Propyl, tert-Butyl und CF₃.

Unter Cycloalkyl sind substituierte oder unsubstituierte C₃-C₂₀-Alkylreste zu verstehen. Bevorzugt sind C₃- bis C₁₀-Alkylreste, besonders bevorzugt C₃- bis C₈-Alkylreste. Die Cycloalkylreste können einen oder mehrere der bezüglich der Alkylreste genannten Substituenten tragen. Beispiele für geeignete cyclische Alkylgruppen (Cycloalkylreste), die ebenfalls unsubstituiert oder mit den vorstehend bezüglich der Alkylgruppen genannten Resten substituiert sein können, sind Cyclopropyl, Cyclobutyl, Cyclopentyl, Cyclohexyl, Cycloheptyl, Cyclooctyl, Cyclononyl und Cyclodecyl. Gegebenenfalls kann es sich auch um polycyclische Ringsysteme handeln, wie Decalinyl, Norbornyl, Bornanyl oder Adamantyl.

Unter Alkyl, welches durch ein oder zwei nicht benachbarte Sauerstoffatome unterbrochen ist, ist beispielsweise 3-Methoxyethyl, 2- und 3-Methoxy-propyl, 2-Ethoxyethyl, 2-und 3-Ethoxypropyl, 2-Propoxyethyl, 2- und 3-Propoxypropyl, 2-Butoxyethyl, 2- und 3-Butoxypropyl, 3,6-Dioxaheptoyl und 3,6-Dioxaoctyl zu nennen.

Als Aryl sind C₆-C₃₀-Arylreste geeignet, die von monocyclischen, bicyclischen oder tricyclischen Aromaten abgeleitet sind, die keine Ringheteroatome enthalten. Sofern es sich nicht um monocyclische Systeme handelt, ist bei der Bezeichnung Aryl für den zweiten Ring auch die gesättigte Form (Perhydroform) oder die teilweise ungesättigte Form (beispielsweise die Dihydroform oder Tetrahyroform), sofern die jeweiligen Formen bekannt und stabil sind, möglich. Das heißt, die Bezeichnung Aryl umfasst in der vorliegenden Erfindung beispielsweise auch bicyclische oder tricyclische Reste, in denen sowohl beide als auch alle drei Reste aromatisch sind, als auch bicyclische oder tricyclische Reste, in denen nur ein Ring aromatisch ist, sowie tricyclische Reste, worin zwei Ringe aromatisch sind. Beispiele für Aryl sind: Phenyl, Naphthyl, Indanyl, 1,2-Dihydronaphthenyl, 1,4-Dihydronaphthenyl, Indenyl, Anthracenyl, Phenanthrenyl oder 1,2,3,4-Tetrahydronaphthyl. Besonders bevorzugt sind C₆-C₁₀-Arylreste, zum Beispiel Phenyl oder Naphthyl, ganz besonders bevorzugt C₆-Arylreste, zum Beispiel Phenyl.

Die Arylreste können unsubstituiert sein oder mit einem mehreren weiteren Resten substituiert sein. Geeignete weitere Reste sind ausgewählt aus der Gruppe bestehend aus C₁-C₂₀-Alkyl, C₆-C₃₀-Aryl oder Substituenten mit Donor- oder Akzeptorwirkung, wobei geeignete Substituenten mit Donor- oder Akzeptorwirkung sind:
C₁-C₂₀-Alkoxy, C₆-C₃₀-Aryloxy, C₁-C₂₀-Alkylthio, C₆-C₃₀-Arylthio, Si(R)₃, Halogenreste, halogenierten C₁-C₂₀-Alkylreste, Carbonyl (-CO(R)), Carbonylthio (-C=O(SR)), Carbonyloxy (- C = O(OR)), Oxycarbonyl (- OC = O(R)), Thiocarbonyl (-SC= O(R)), Amino (-NR₂), OH, Pseudohalogenreste, Amido (- C = O (NR)), -N(R) C = O (R), Phosphonat (- P(O) (OR)₂, Phosphat (-OP(O) (OR)₂), Phosphin (-PR₂), Phosphinoxid (-P(O)R₂), Sulfat (-OS(O)₂OR), Sulfoxid (-S(O)R), Sulfonat (-S(O)₂OR), Sulfonyl (-S(O)₂R), Sulfonamid (-S(O)₂NR₂), NO₂, Boronsäureester (-OB(OR)₂), Imino (-C = NR₂)), Boranreste, Stannanreste, Hydrazinreste, Hydrazonreste, Oximreste, Nitroso-Gruppen, Diazo-Gruppen, Vinylgruppen, (=Sulfonat) und Boronsäuregruppen, Sulfoximine, Alane, Germane, Boroxime und Borazine.

Bevorzugte Substituenten mit Donor- oder Akzeptorwirkung sind ausgewählt aus der Gruppe bestehend aus:
C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR₃, wobei die drei Reste R bevorzugt unabhängig voneinander substituiertes oder unsubstituiertes Alkyl oder substituiertes oder unsubstituiertes Phenyl bedeuten, Halogenresten, bevorzugt F, Cl, Br, besonders bevorzugt F oder Cl, ganz besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diphenylamino; OH, Pseudohalogenresten, bevorzugt CN, SCN oder OCN, besonders bevorzugt CN, -C(O)OC₁-C₄-Alkyl, bevorzugt -C(O)OMe, P(O)R₂, bevorzugt P(O)Ph₂ oder SO₂R₂, bevorzugt SO₂Ph.

R bedeutet in den zuvor genannten Gruppen insbesondere C₁-C₂₀-Alkyl oder C₆-C₃₀-Aryl.

C₁-C₆-Alkylen-COO-Alkyl, C₁-C₆-Alkylen-O-CO-Alkyl und C₁-C₆- Alkylen-O-CO-O-Alkyl leiten sich von den zuvor beschriebenen Alkylresten durch Anbindung an die Gruppierungen C₁-C₆-Alkylen-COO, C₁-C₆-Alkylen-O-CO und C₁-C₆- Alkylen-O-CO-O ab, worin die C₁-C₆-Alkylen-Einheiten vorzugsweise linear sind. Insbesondere kommen C₂-C₄-Alkylen-Einheiten in Betracht.

Unter Arylalkyl sind insbesondere Aryl-C₁-C₂₀-alkylgruppen zu nennen. Sie leiten sich von den zuvor aufgeführten Alkyl- und Arylgruppen durch formalen Ersatz eines Wasserstoffatoms der linearen oder verzweigten Alkylkette durch eine Arylgruppe ab. Beispielsweise sei als bevorzugte Arylalkylgruppe Benzyl genannt.
Unter Hetaryl sind unsubstituierte oder substituierte Heteroarylreste mit 5 bis 30 Ringatomen, die monocyclisch, bicyclisch oder tricyclisch sein können, zu verstehen, die sich zum Teil vom vorstehend genannten Aryl ableiten lassen, in dem im Aryl-Grundgerüst mindestens ein Kohlenstoffatom durch ein Heteroatom ersetzt ist. Bevorzugte Heteroatome sind N, O und S. Besonders bevorzugt weisen die Hetarylreste 5 bis 13 Ringatome auf. Insbesondere bevorzugt ist das Grundgerüst der Heteroarylreste ausgewählt aus Systemen wie Pyridin und fünfgliedrigen Heteroaromaten wie Thiophen, Pyrrol, Imidazol oder Furan. Diese Grundgerüste können gegebenenfalls mit einem oder zwei sechsgliedrigen aromatischen Resten anelliert sein. Geeignete anellierte Heteroaromaten sind Carbazolyl, Benzimidazolyl, Benzofuryl, Dibenzofuryl oder Dibenzothiophenyl. Das Grundgerüst kann an einer, mehreren oder allen substituierbaren Positionen substituiert sein, wobei geeignete Substituenten dieselben sind, die bereits unter der Definition von C₆-C₃₀-Aryl genannt wurden. Bevorzugt sind die Hetarylreste jedoch unsubstituiert. Geeignete Hetarylreste sind zum Beispiel Pyridin-2-yl, Pyridin-3-yl, Pyridin-4-yl, Thiophen-2-yl, Thiophen-3-yl, Pyrrol-2-yl, Pyrrol-3-yl, Furan-2-yl, Furan-3-yl und Imidazol-2-yl sowie die entsprechenden benzanellierten Reste, insbesondere Carbazolyl, Benzimidazolyl, Benzofuryl, Dibenzofuryl oder Dibenzothiophenyl.

In den photoaktiven Schichten kann die Komponente K1 die Rolle des Elektronendonors übernehmen, entsprechend kommt dann der Komponente K2 die Rolle des Elektronenakzeptors zu. Alternativ kann aber auch die die Komponente K1 die Rolle des Elektronenakzeptors annehmen, entsprechend fungiert dann Komponente K2 als Elektronendonor. In welcher Weise die jeweilige Komponente wirkt hängt von der Energie des HOMO bzw. LUMO der Komponente K1 im Verhältnis zur Energie des HOMO bzw. LUMO der Komponente K2 ab. Bei den Verbindungen der Komponente K1 handelt es sich typischerweise um Merocyanine, welche üblicherweise als Elektronendonoren in Erscheinung treten. Insbesondere ist dies der Fall, wenn als Komponente K2 Rylen- oder Fulleren-Derivate Verwendung finden, welche dann in der Regel als Elektronenakzeptoren wirken. Diese Rollen können sich im konkreten Einzelfall jedoch vertauschen. Anzumerken ist auch, dass Komponente K2 ebenfalls der strukturellen Definition der Komponente K1 gehorchen kann, so dass eine Verbindung der Formel la die Rolle des Elektronendonors und eine andere Verbindung der Formel la die Rolle des Elektronenakzeptors übernehmen kann.

Bevorzugte erfindungsgemäß zu verwendende Verbindungen der Formel la in Komponente K1 zeichnen sich dadurch aus, dass für n gleich 1 L eine Gruppierung bedeutet, die ausgewählt ist aus der Gruppe 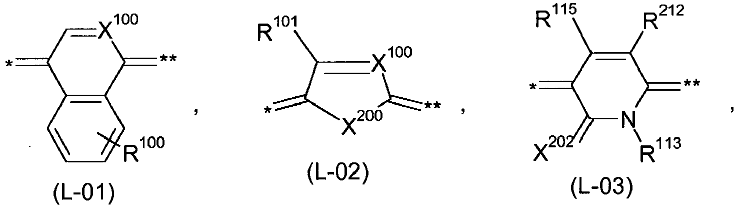 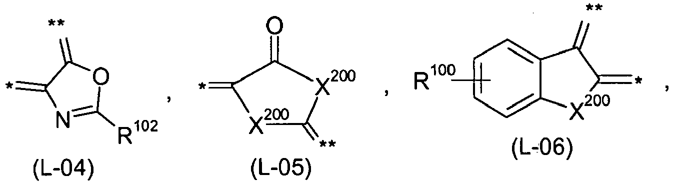 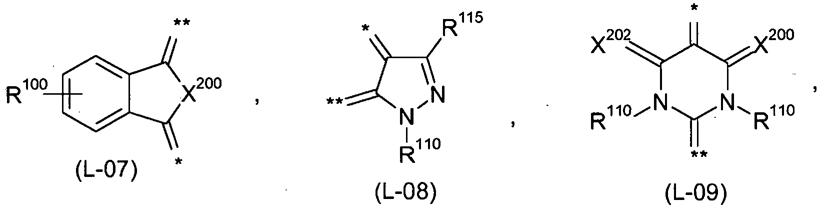 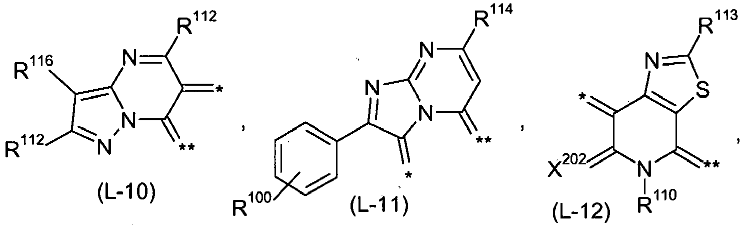 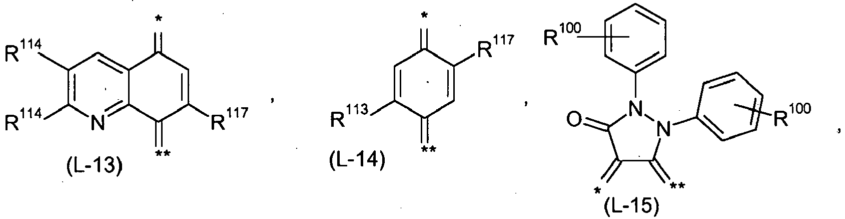 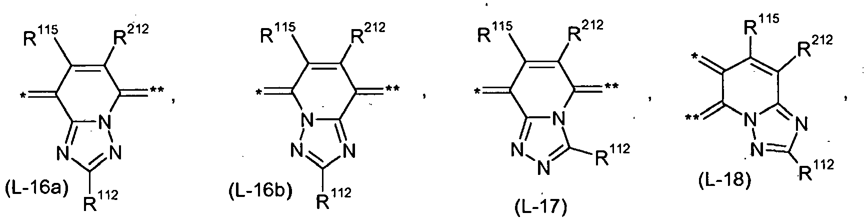 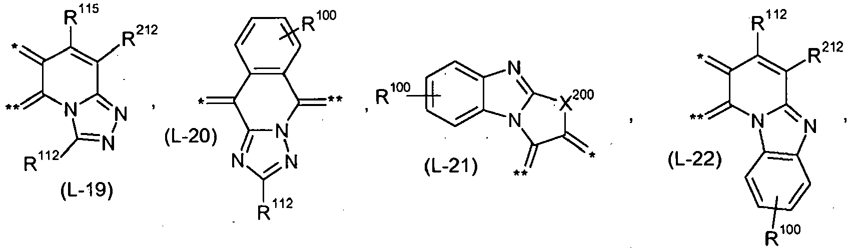 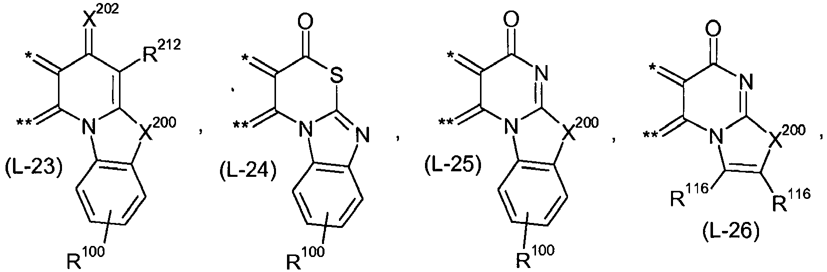 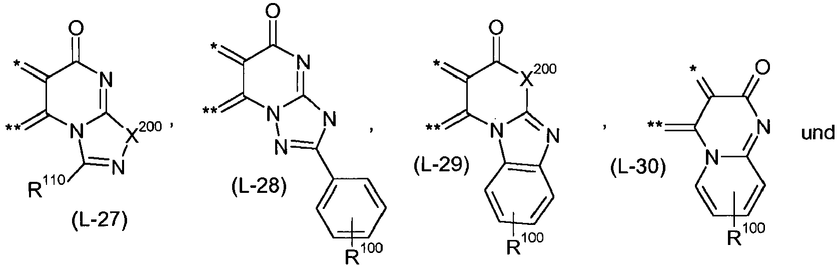 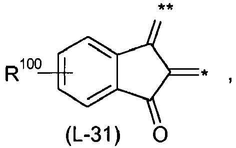 worin bedeuten
- R¹⁰²: Arylalkyl, Aryl oder Hetaryl,
- R¹¹²: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, OR¹¹⁰ oder SR¹¹⁰,
- R¹¹³: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, Hetaryl, NH-Aryl, N(Aryl)₂, NHCO-R¹⁰¹ oder N(CO-R¹⁰¹)₂,
- R¹¹⁴: H, Alkyl oder teil- oder perfluoriertes Alkyl, C₁-C₆-Alkylen-COO-Alkyl, C₁-C₆-Alkylen-O-CO-Alkyl oder C₁-C₆- Alkylen-O-CO-O-Alkyl,
- R¹¹⁵: H, Alkyl, teil- oder perfluoriertes Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, NHCO-R¹⁰¹ oder N(CO-R¹⁰¹)₂,
- R¹¹⁶: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, CO₂R¹¹⁰ oder CN
- R¹¹⁷: H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, OR¹¹⁰, SR¹¹⁰ Halogen oder Hetaryl,
- R²¹²: H, CN, CONR¹¹⁰ oder COR¹⁰¹,
- X²⁰²: zweimal H, O oder S,
worin * und ** die Anbindung an die Einheit X¹⁰⁰ bzw. W bezeichnet, die Kohlenstoffketten der Alkyl- und Cycloalkyl-Reste durch ein oder zwei nicht benachbarte Sauerstoffatome unterbrochen sein können, und
die übrigen Variablen die Bedeutung wie in Anspruch 1 besitzen, und die zuvor sowie in Anspruch 1 genannten Variablen, sofern sie mehr als einmal auftreten, gleich oder voneinander verschieden sein können.

Weitere bevorzugt zu verwendenden Mischungen, auch unter Berücksichtigung der zuvor beschriebenen Bevorzugungen, zeichnen sich dadurch aus, dass es sich bei Komponente K2 um ein oder mehrere Verbindungen ausgewählt aus der Gruppe
a) Fullerene und Fullerenderivate,
b) polycyclische aromatische Kohlenwasserstoffe und deren Derivate, insbesondere Naphthalin und dessen Derivate, Rylene, insbesondere Perylen, Terrylen und Quaterrylen, und deren Derivate, Azene, insbesondere Anthrazen, Tetrazen, in besondere Rubren, Pentazen und deren Derivate, Pyren und dessen Derivate, Coronen und Hexabenzocoronen und deren Derivate,
c) Chinone, Chinondimethane und Chinondiimine und deren Derivate,
d) Phthalocyanine und Subphthalocyanine und deren Derivate,
e) Porphyrine, Tetraazaporphyrine und Tetrabenzoporphyrine und deren Derivate,
f) Thiophene, oligo-Thiophene, kondensierte/anellierte Thiophene, wie Thienothiophen und Bithienothiophen, und deren Derivate,
g) Thiadiazole und deren Derivate,
h) Carbazole und Triarylamine und deren Derivate,
i) Indanthrone, Violanthrone und Flavanthone und deren Derivate,
j) Fulvalene, Tetrathiafulvalene und Tetraselenafulvalene und deren Derivate und
k) Diketopyrrolopyrrole und deren Derivate
handelt.

Insbesondere finden erfindungsgemäße Verwendung, auch unter Berücksichtigung der zuvor beschriebenen Bevorzugungen, Mischungen, welche sich dadurch auszeichnen, dass es sich bei Komponente K2 um ein oder mehrere Fullerene und/oder Fulleren-Derivate handelt.

Als leicht zugängliche Fulleren-Derivate kommen insbesondere Verbindungen der allgemeinen Formel k2 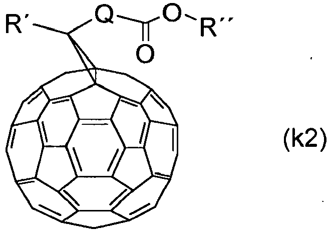 in Frage,
worin bedeuten
- Q: C₁-C₁₀-Alkylen,
- R': Aryl oder Arylalkyl
und
- R": Alkyl.

Zur Definition von Aryl, Arylalkyl und Alkyl wird auf das bereits zuvor Gesagte verwiesen.
Unter C₁-C₁₀-Alkylen ist insbesondere eine lineare Kette -(CH₂)ₘ-, mit m gleich 1, 2, 3, 4, 5, 6, 7, 8, 9 oder 10, zu verstehen.

Insbesondere finden erfindungsgemäß solche Fulleren-Derivate Verwendung, in welchen R' einen C₁-C₄-Alkyl-, insbesondere einen Methylrest, bezeichnet, Q für eine Propylen-Kette -(CH₂)₃- und R" für ein gegebenenfalls substituiertes Phenyl oder 2-Thienyl steht. Vorzugsweise handelt es sich bei dem Fulleren-Derivat um [6,6]-Phenyl-C₆₁-butylsäuremethylester ("PCBM").

Besonders bevorzugt kommen zur Verwendung, auch unter Berücksichtigung der zuvor genannten Bevorzugungen, Mischungen, in welchen es sich bei Komponente K2 um ein oder mehrere Fullerene handelt.

Als mögliche Fullerene sind zu nennen C₆₀, C₇₀, C₇₆, C₈₀, C₈₂, C₈₄, C₈₆, C₉₀ und C₉₄, insbesondere das C₆₀ und C₇₀. Einen Überblick über Fullerene, welche erfindungsgemäß verwendet werden können, liefert beispielsweise die Monografie von A. Hirsch, M. Brettreich, "Fullerenes: Chemistry and Reactions", Wiley-VCH, Weinheim 2005.

Insbesondere handelt es sich bei Komponente K2 um ein C60-Fulleren der Formel k2

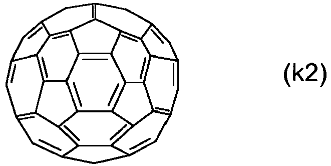

Die erfindungsgemäß zu verwendenden Mischungen zeichnen sich dadurch aus, dass die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen.

Herstellungsbedingt ist es im Einzelfall möglich, dass nicht eine explizit gezeigte Verbindung der Formel Ia, sondern eine dazu isomere Verbindung erhalten wird oder dass auch Mischungen von Isomeren erhalten werden. Erfindungsgemäß sollen dementsprechend auch die isomeren Verbindungen der Formel la und die Isomeren der entsprechenden bevorzugten Verbindungen sowie Mischungen von Isomeren umfasst sein.

Die Synthese der Verbindungen der allgemeinen Formel la sind dem Fachmann bekannt oder lassen sich in Anlehnung an bekannte Syntheseverfahren herstellen. Beispielsweise sind hinsichtlich entsprechender Synthesen die nachfolgenden Publikationen zu nennen:
DE 195 02 702 A1, EP 416 434 A2, EP 509 302 A1, EP 291 853 A2, US 5,147,845, US 5,703,238;
"ATOP Dyes. Optimization of a Multifunctional Merocyanine Chromophore for High Refractive Index Modulation in Photorefractive Materials", F. Würthner, S. Yao, J. Schilling, R. Wortmann, M. Redi- Abshiro, E. Mecher, F. Gallego-Gomez, K. Meerholz, J. Am. Chem. Soc. 2001, 123, 2810 - 2814;
"Merocyaninfarbstoffe im Cyaninlimit: eine neue Chromophorklasse für photorefraktive Materialien; Merocyanine Dyes in the Cyanine Limit: A New Class of Chromophores for Photorefractive Materials", F. Würthner, R. Wortmann, R. Matschiner, K. Lukaszuk, K. Meerholz, Y. De Nardin, R. Bittner, C. Bräuchle, R. Sens , Angew. Chem. 1997, 109, 2933 - 2936; Angew. Chem. Int. Ed. Engl. 1997, 36, 2765 - 2768;
"Electrooptical Chromophores for Nonlinear Optical and Photorefractive Applications", S. Beckmann, K.-H. Etzbach, P. Krämer, K. Lukaszuk, R. Matschiner, A. J. Schmidt, P. Schuhmacher, R. Sens, G. Seybold, R. Wortmann, F. Würthner, Adv. Mater. 1999, 11, 536 - 541;
"DMF in Acetic Anhydride: A Useful Reagent for Multiple- Component Syntheses of Merocyanine Dyes", F. Würthner, Synthesis 1999, 2103 - 2113;
Ullmanns' Encyclopedia of industrial Chemistry, Vol. 16, 5th Edition (Ed. B. Elvers, S. Hawkins, G. Schulz), VCH 1990 im Kapitel "Methine Dyes and Pigments", S. 487 - 535 von R. Raue (Bayer AG).

Insbesondere sind die Publikationen zu nennen:
T. Zimmermann, J. Heterocycl. Chem., 2000, 37,1571; (Verbindungen la)
T. Zimmermann and O. Brede, J. Heterocycl. Chem., 2004, 41, 103; (Verbindungen la)
Nachfolgend seien exemplarisch erfindungsgemäß verwendbare Verbindungen der allgemeinen Formel la gezeigt:

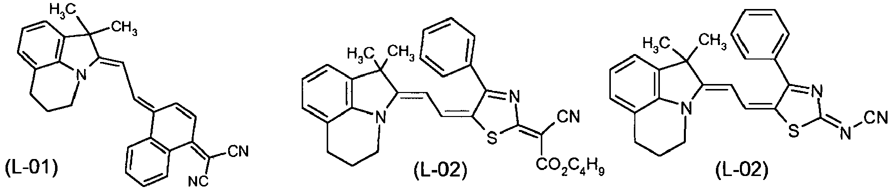

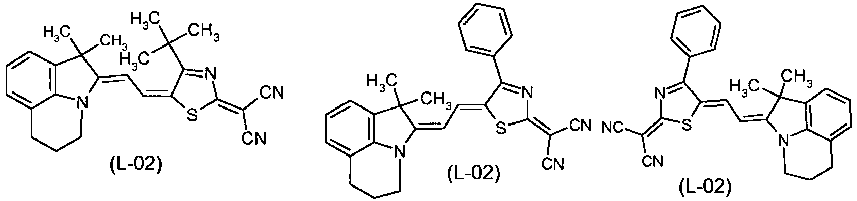

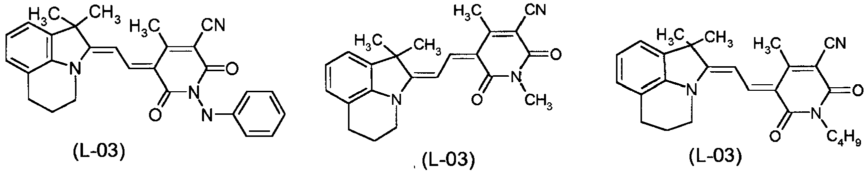

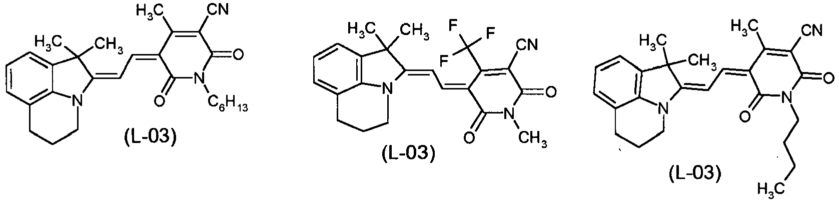

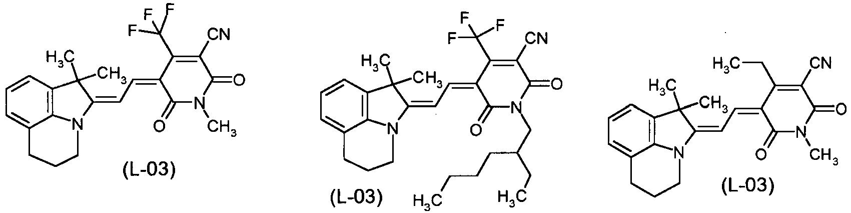

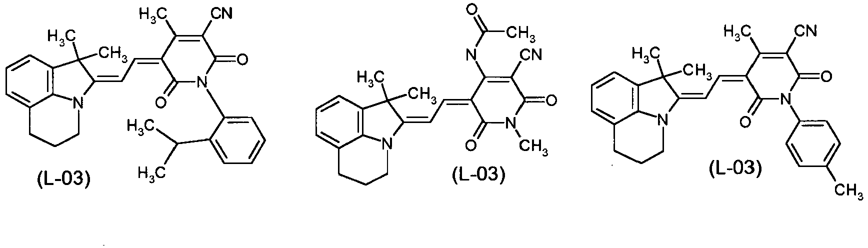

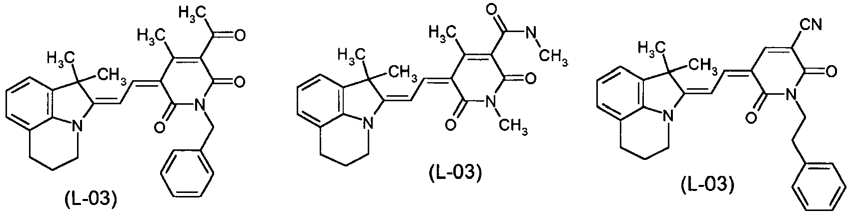

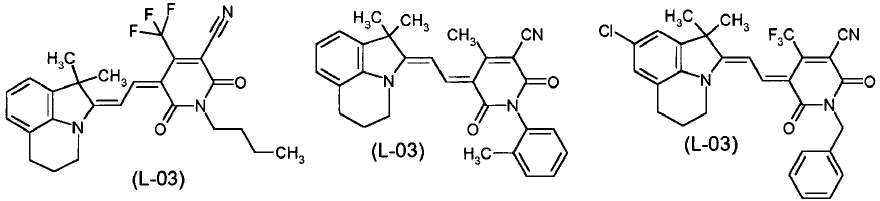

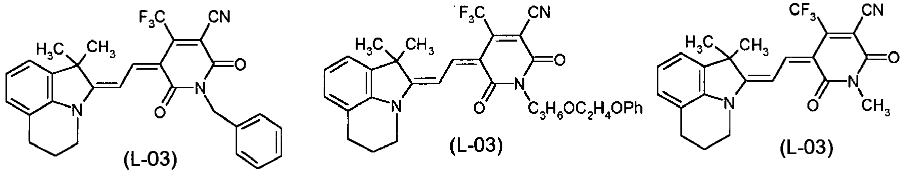

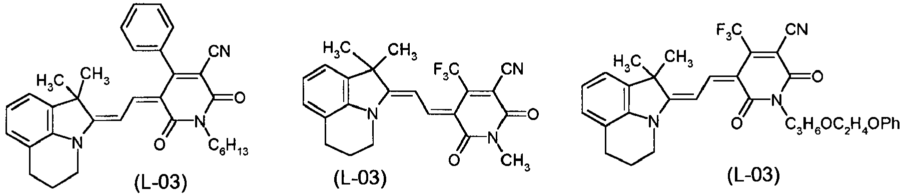

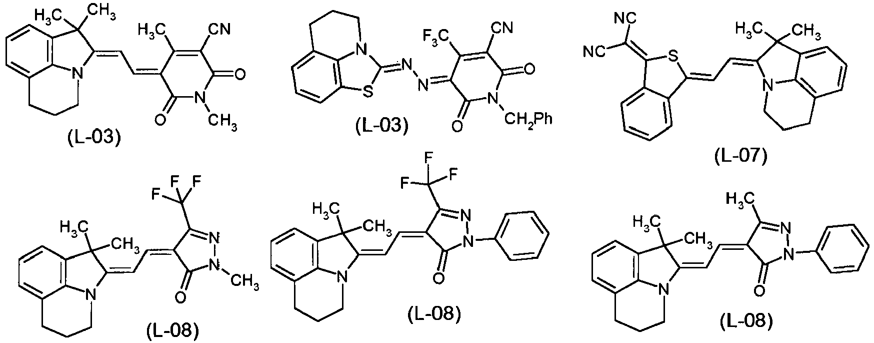

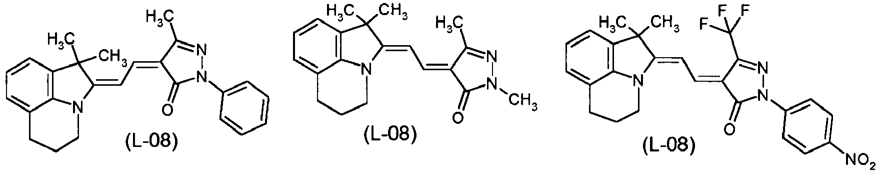

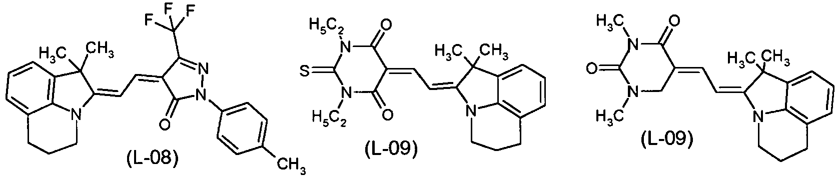

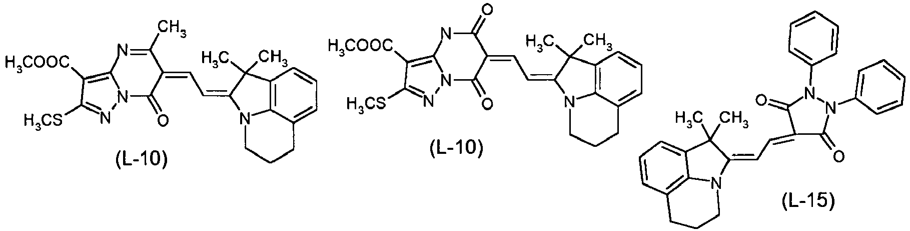

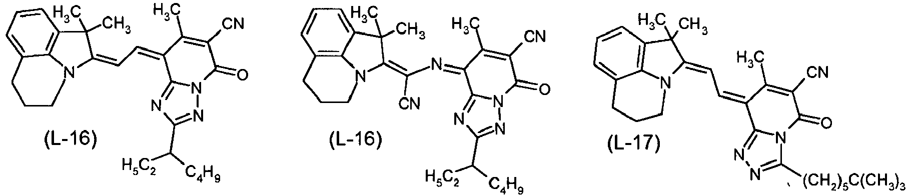

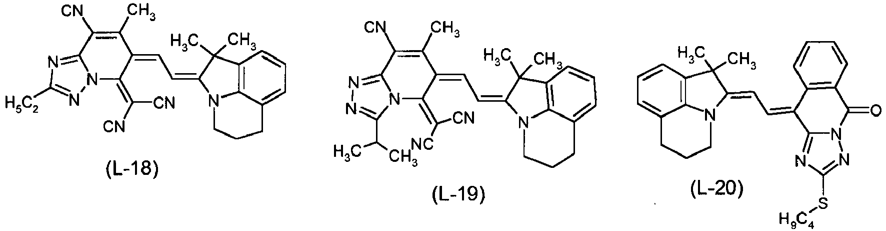

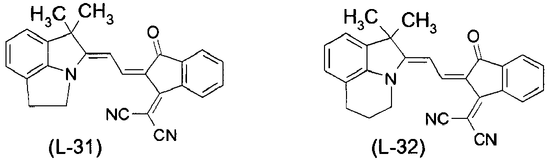

Verbindungen der Formel la, in welchen die Einheit L fehlt (n = 0), sind exemplarisch nachfolgend gezeigt:

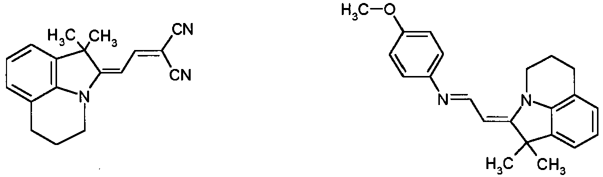

Weiter wird im Rahmen der vorliegenden Erfindung unter anderem ein Verfahren zur Herstellung von photoaktiven Schichten beansprucht, welches dadurch gekennzeichnet ist, dass ein oder mehrere der eingangs gezeigten Verbindungen der allgemeinen Formel la der Komponente K1, auch unter Berücksichtigung ihrer Bevorzugungen, und ein oder mehrere Verbindungen der Komponente K2, ebenfalls unter Berücksichtigung ihrer Bevorzugungen, gleichzeitig, nacheinander oder in alternierender Abfolge durch Vakuumsublimation auf einem Substrat abgeschieden werden.

Insbesondere zeichnet das Verfahren aus, dass sich die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, auf dem Substrat abgeschieden befindet, wobei sich die Anteile der Komponenten K1 und K2, jeweils bezogen auf die Gesamtmasse der Komponenten K1 und K2, zu 100 Massen-% ergänzen.

Weiter werden im Rahmen der vorliegenden Erfindung organische Solarzellen und organische Photodetektoren beansprucht, welche photoaktive Schichten enthalten, die unter Verwendung der zuvor beschriebenen, die Komponenten K1 und K2 enthaltenden Mischungen, oder unter Verwendung der ebenfalls zuvor beschriebenen bevorzugten Ausführungsformen der Mischungen hergestellt worden sind.

Organische Solarzellen sind meist schichtförmig aufgebaut und umfassen in der Regel zumindest die folgenden Schichten: Elektrode, photoaktive Schicht und Gegenelektrode. Diese Schichten befinden sich in der Regel auf einem dafür üblichen Substrat. Geeignete Substrate sind z.B. oxidische Materialien, wie etwa Glas, Quarz, Keramik, SiO₂, etc., Polymere, wie etwa Polyvinylchlorid, Polyolefine, z.B. Polyethylen und Polypropylen, Polyester, Fluorpolymere, Polyamide, Polyurethane, Polyalkyl(meth)-acrylate, Polystyrol und Mischungen und Komposite davon, und Kombinationen der zuvor aufgeführten Substrate.

Als Materialien für die eine Elektrode eignen sich insbesondere Metalle, wie z.B. die Alkalimetalle Li, Na, K, Rb und Cs, die Erdalkalimetalle Mg, Ca und Ba, Pt, Au, Ag, Cu, Al, In, Metalllegierungen, z.B. auf Basis Pt, Au, Ag, Cu, etc. und spezielle Mg/Ag-Legierungen, des weiteren aber auch Alkalimetallfluoride, wie LiF, NaF, KF, RbF und CsF, und Mischungen aus Alkalimetallfluoriden und Alkalimetallen. Bevorzugt wird als Elektrode ein das einfallende Licht im Wesentlichen reflektierendes Material eingesetzt. Dazu zählen beispielsweise Metallfilme aus Al, Ag, Au, In, Mg, Mg/Al, Ca, etc.

Die Gegenelektrode besteht aus einem, gegenüber einfallendem Licht im Wesentlichen transparenten Material, z. B. ITO, dotiertes ITO, ZnO, TiO₂, Cu, Ag, Au und Pt, wobei die letztgenannten Metalle in entsprechend dünnen Schichten vorliegen.

Als "transparent" soll hierbei eine Elektrode/Gegenelektrode angesehen werden, wenn mindestens 50 % der Strahlungsintensität in dem Wellenlängen-Bereich transmittiert wird, in welchem die photoaktive Schicht Strahlung absorbiert. Im Falle mehrerer photoaktiver Schichten soll eine Elektrode/Gegenelektrode als "transparent" angesehen werden, wenn mindestens 50 % der Strahlungsintensität in den WellenlängenBereichen transmittiert wird, in welchen die photoaktiven Schichten Strahlung absorbieren.

Zusätzlich zur photoaktiven Schicht können eine oder mehrere weitere Schichten in den erfindungsgemäßen organischen Solarzellen und Photodetektoren vorhanden sein, z.B. Elektronen transportierende Schichten ("ETL", electron transporting layers) und/oder Löcher transportierende Schichten ("HTL", hole transporting layers) und/oder blockierende Schichten, z.B. Excitonen blockierende Schichten ("EBL", excition blocking layers), die üblicherweise das einfallende Licht nicht absorbieren, oder auch Schichten, welche als Ladungstransportschichten dienen und gleichzeitig die Kontaktierung zu einer oder beiden Elektroden der Solarzelle verbessern. Die ETL und HTL können auch dotiert sein, so dass sich Zellen vom p-i-n-Typ ergeben, wie sie beispielsweise in der Publikation von J. Drechsel et al., Thin Solid Films 451 - 452 (2004), 515 - 517, beschrieben sind.

Übliche Aufbauten A), B) und C) von Solarzellen sind nachfolgend beschrieben:
A) Zweischichtaufbau:
   Der Aufbau umfasst folgende Schichten:
      - 16: Metallelektrode (Kathode)
      - (15: optionale EBL und/oder ETL)
      - 14: Elektronenakzeptor-Schicht
      - 13: Elektronendonor-Schicht
      - (12: optionale HTL)
      - 11: Transparente Elektrode (Anode)

Bei Schicht 11 handelt es sich um eine transparente, leitfähige Schicht, beispielsweise ITO, FTO oder ZnO, welche gegebenenfalls z.B. mit Sauerstoffplasma, UV/Ozon-Spülung etc. vorbehandelt ist. Diese Schicht muss einerseits so dünn sein, dass nur geringe Lichtabsorption auftritt, jedoch andererseits dick genug, um einen zufriedenstellenden lateralen Ladungstransport innerhalb der Schicht zu gewährleisten. Üblicherweise beträgt die Dicke der Schicht 20 - 200 nm und sie wird auf einem Substrat wie Glas oder einem flexiblen Polymer (beispielsweise PET) aufgebracht.

Schicht 12 besteht aus einer oder mehreren HTLs mit einem hohen lonisierungspotential (> 5,0 eV, vorzugsweise 5,5 eV). Diese Schicht kann entweder aus organischem Material bestehen, wie Poly(3,4-ethylendioxythiophen) mit Poly(styrolsulfonat)(PEDOT-PSS) dotiert, oder beispielsweise aus Ir-DPBIC (Tris-N,N'-Diphenylbenzimidazol-2-yliden-iridium(III)), N,N'-Diphenyl-N,N'-bis (3-methylphenyl)-1,1'-diphenyl-4, 4'-diamin (α-NPD) und/oder 2,2',7,7'-Tetrakis(N,N-di-p-methoxyphenylamin)-9,9'-spirobifluoren (spiro-MeOTAD), oder aus anorganischem Material, wie WO₃, MoO₃, usw. Üblicherweise beträgt die Schichtdicke 0 - 150 nm. Für den Fall, dass Schicht 12 aus organischem Material aufgebaut ist, kann sie mit einem p-Dotierstoff versetzt werden, dessen LUMO-Energie im gleichen oder niedrigeren Energiebereich liegt wie das HOMO der HTL. Solche Dotierstoffe sind beispielsweise 2,3,5,6-Tetrafluoro-7,7,8,8-tetracyano-quinodimethan (F₄TCNQ), WO₃, MoO₃, oder die in der Schrift WO 2007/071450 A1 beschriebenen Substanzen.

Schicht 13 besteht aus dem Elektronendonor. Üblicherweise sollte die Schicht so dick sein, dass sie möglichst viel Licht absorbiert, andererseits aber ausreichend dünn, um die gebildeten Ladungen effektiv abführen zu können. In der Regel beträgt die Dicke 5 - 200 nm.

Schicht 14 besteht aus dem Elektronenakzeptor. Wie für Schicht 13 sollte auch hier die Dicke ausreichend sein, um so viel Licht wie möglich zu absorbieren, andererseits müssen jedoch die gebildeten Ladungen effektiv abgeleitet werden. Üblicherweise weist diese Schicht ebenfalls eine Dicke 5 - 200 nm auf.

Schicht 15 ist eine EBL/ETL und sollte eine größere optische Bandlücke aufweisen als die Materialien der Schicht 14, um die Exitonen zu reflektieren, trotzdem jedoch noch über ausreichende Elektronentransporteigenschaften verfügen. Geeignete Verbindungen sind 2,9-Dimethyl-4,7-diphenyl-1,10-phenanthrolin (BCP), 4,7-Diphenyl-1,10-phenanthrolin (Bphen), 1,3-Bis[2-(2,2'-bipyridin-6-yl)1,3,4-oxadizo-5-yl]benzol (BPY-OXD), ZnO,TiO₂ etc. Für den Fall einer organischen Schicht kann diese mit einem n-Dotierstoff versehen werden, dessen HOMO ähnliche oder geringere Energie besitzt, als das LUMO der Elektronen transportierenden Schicht. Geeignete Materialien sind Cs₂CO₃, Pyronin B (PyB), beschrieben beispielsweise in der Schrift WO 2003/070822 A2, Rodamine B, beschrieben beispielsweise in der Schrift WO 2005/036667 A1, Cobaltocen und die in der Schrift WO 2007/071450 A1 erwähnten Verbindungen. Die Schichtdicke beträgt üblicherweise 0-150 nm.

Schicht 16 (Kathode) besteht aus einem Material mit geringer Austrittsarbeit. Beispielsweise handelt es sich hier um Metalle wie Ag, Al, Ca, Mg oder deren Mischungen. Die Schichtdicke beträgt üblicherweise 50-1000 nm und sollte so ausreichend gewählt werden, dass das meiste Licht im Wellenlängenbereich von 350 - 1200 nm reflektiert wird.

Die üblichen Drücke während der Gasphasenabscheidung liegen zwischen 10⁻⁴ und 10⁻⁹ mbar. Die Abscheidungsrate variiert in der Regel zwischen 0,01 nm/Sekunde und 10 nm/Sekunde. Die Temperatur des Substrats während der Abscheidung kann man in einem Temperaturbereich zwischen -100 °C und 200 °C variieren, um die Morphologie der entsprechenden Schicht gezielt zu beeinflussen. Die Abscheidungsrate liegt üblicherweise zwischen 0,1 nm/Sekunde und 2,0 nm/Sekunde.

Für die Abscheidung der Schichten kann ebenfalls das in WO 1999/025894 A1 beschriebene Verfahren eingesetzt werden.

Nach dem Abscheiden der aktiven Schicht (Schicht 13 und 14) oder nach dem Fertigstellen der gesamten Zelle, d.h. nach dem Abscheiden von Schicht 16, kann sich eine Temperung bei 60 °C bis 100 °C für die Dauer von wenigen Minuten bis hin zu einigen Stunden anschließen, um einen innigeren Kontakt der Schichten zu erreichen. Ebenso kann zu diesem Zweck eine Behandlung mit Lösungsmitteldampf , beispielsweise von Toluol, Xylol, Chloroform, N-Methylpyrrolidon, Dimethylformamid, Ethylacetat, Chlorbenzol und Dichlormethan oder anderen Lösungsmitteln für die entsprechende Dauer vorgenommen werden.
B) Bulk-Heterojunction-(BHJ)-Aufbau:
   Der Aufbau umfasst folgende Schichten:
      - 26: Metallelektrode (Kathode)
      - (25: optionale EBL und/oder ETL)
      - 24: ETL
      - 23: Elektronenakzeptor-Elektronendonor-Schicht
      - (22: optionale HTL)
      - 21: Transparente Elektrode (Anode)

Die Schichten 21 und 22 entsprechen den Schichten 11 und 12 aus Aufbau A).

Die Schicht 23 kann durch gemeinsames Verdampfen oder durch Lösungsprozessierung mit üblichen Lösungsmitteln hergestellt werden - hierauf wird weiter unten eingegangen - hergestellt werden. Der Anteil des Elektronendonors beträgt in beiden Fällen vorzugsweise 10 bis 90 Massen-%, insbesondere 20 bis 80 Massen-%. Der Anteil an Elektronenakzeptor ergibt sich ergänzend zu 100 Massen-%. Auch hier muss die Schicht so dick sein, dass ausreichend Licht absorbiert wird, jedoch immer noch so dünn, dass die Ladungsträger effektiv abgeführt werden können. Üblicherweise ist die Schicht 5 - 500 nm dick.

Die ETL-Schicht 24 kann aus ein oder mehreren Schichten von Materialien mit einer geringen LUMO-Energie (<3,5 eV) bestehen. Diese Schichten können entweder aus organischen Verbindungen, wie C60-Fulleren, BCP, Bphen oder BPY-OXD, oder aus anorganischen Verbindungen, wie ZnO, TiO₂ etc. bestehen und sind in der Regel zwischen 0 nm - 150 nm dick. Im Falle von organischen Schichten können diese mit den bereits oben erwähnten Dotierstoffen versetzt sein.

Die Schichten 25 und 26 entsprechen den Schichten 15 und 16 aus Aufbau A). Ebenso entsprechen die Abscheidungsraten und Nachbehandlungen denjenigen aus Aufbau A).

### C) Tandemzelle

Der Aufbau umfasst folgende Schichten:
- 36: Metallelektrode (Kathode)
(zusätzliche Rekombinationsschichten und Subzellen)
- 34: 2. Subzelle
- 33: Rekombinationsschicht
- 32: 1. Subzelle
- 31: Transparente Elektrode (Anode)

Tandemzellen enthalten zwei oder mehrere Subzellen, die meist in Serie geschaltet sind, wobei zwischen den einzelnen Subzellen Rekombinationsschichten angeordnet sind.

Schicht 31 entspricht vom Aufbau den zuvor genannten Schichten 11 und 21 aus Aufbau A) und B).

Die Schichten 32 und 34 sind individuelle Subzellen und entsprechen in ihrer Funktion einzelnen Zellen wie unter Aufbau A) und B) mit dem Unterschied, dass sie keine Elektroden 11/16 bzw. 21/26 enthalten. Die Subzellen bestehen daher aus den Schichten 12 bis 15 des Aufbaus A) bzw. 22 bis 25 des Aufbaus B).

Die Subzellen können als Komponente K1 bzw. K2 entweder alle Merocyanine enthalten oder eine Subzelle enthält ein oder mehrere Merocyanine und die übrigen Subzellen enthalten Kombinationen anderer Materialien, wie beispielsweise C60-Fulleren/Zn-Phthalocyanin, Oligothiophen (beispielsweise DCV5T)/C60-Fulleren (wie in WO 2006/092134 A1 beschrieben), oder eine der Subzellen ist eine Farbstoffsensibilisierte Solarzelle (DSSC) oder eine Polymerzelle, wie beispielsweise in der Kombination P3HT/PCBM. Des Weiteren können sowohl Zellen vom Aufbau A) als auch vom Aufbau B) als Subzellen enthalten sein. In den genannten Fällen ist es am günstigsten, wenn die Kombination der Materialien/Subzellen so gewählt wird, dass die Lichtabsorptionen der Subzellen nicht zu stark überlappen, sondern in Summe das Spektrum des Sonnenlichts abdecken, was zu einer Erhöhung der Stromausbeute führt. Unter Berücksichtigung von optischen Interferenzen, welche in der Zelle stattfinden, ist es zudem sinnvoll, eine Subzelle mit Absorption im kürzeren Wällenlängenbereich näher an der Elektrode 36 zu plazieren, als eine Subzelle mit Absorption im längeren Wellenlängenbereich.

Durch die Rekombinationsschicht 33 wird die Rekombination entgegengesetzt geladenen Ladungsträger in benachbarten Subzellen bewirkt. Als wirksame Bestandteile in der Rekombinationsschicht können Metallcluster, beispielsweise aus Ag oder Au, wirken oder die Rekombinationsschicht besteht aus einer Kombination hochdotierter n- und p-leitenden Schichten (wie beispielsweise in WO 2004/083958 A2 beschrieben). Im Fall der Verwendung von Metallclustern werden üblicherweise Schichtdicken von 0,5 - 20 nm, im Fall der kombinierten dotierten Schichten Dicken von 5 - 150 nm eingestellt. Weitere Subzellen können auf die Subzelle 34 aufgebracht werden, wobei dann ebenfalls weitere Rekombinationsschichten, wie Schicht 33, vorhanden sein müssen.

Das Material für die Elektrode 36 hängt von der Polarität der Subzellen ab. Bei normaler Polarität kommen die bereits erwähnten Metalle mit geringer Austrittsarbeit, wie beispielsweiese Ag, Al, Mg und Ca, in Betracht. Bei invertierter Polarität verwendet man üblicherweise Materialien mit hoher Austrittsarbeit, wie beispielsweise Au, Pt, PEDOT-PSS.

Bei Tandemzellen, welche in Serie geschaltete Subzellen enthalten, addieren sich die Teilspannungen, der Gesamtstrom ist aber durch die Subzelle mit der geringsten Stromstärke/Stromdichte limitiert. Daher sollten die einzelnen Subzellen so optimiert werden, dass deren indiviuellen Stromstärken/Stromdichten ähnliche Werte aufweisen.

Der Aufbau organischer Solarzellen ist des Weiteren z.B. in den Schriften WO 2004/083958 A2, US 2005/0098726 A1 und US 2005/0224905 A1 beschrieben, worauf hier in vollem Umfang Bezug genommen wird.

Photodetektoren besitzen im Wesentlichen einen zu organischen Solarzellen analogen Aufbau, sie werden jedoch mit geeigneter Vorspannung betrieben, welche bei Einwirkung von Strahlungsenergie einen entsprechenden Stromfluss als Messantwort generiert.

Die Prozessierung der photoaktiven Schichten kann aus Lösung erfolgen. Hierbei können die Komponenten K1 und K2 bereits gemeinsam gelöst, aber auch separat als Lösung der Komponente K1 und Lösung der Komponente K2 vorliegen, wobei die Vermischung der entsprechenden Lösungen in letzterem Fall kurz vor der Aufbringung auf die darunterliegende Schicht erfolgt. Die Konzentrationen der Komponenten K1 und K2 belaufen sich in der Regel auf etwa einige g/l bis einige zehn g/l Lösungsmittel.

Als Lösungsmittel eignen sich alle Flüssigkeiten, welche rückstandsfrei verdampfen und eine ausreichende Löslichkeit für die Komponenten K1 und K2 aufweisen. Hier kommen beispielsweise in Frage aromatische Verbindungen, wie etwa Benzol, Toluol, Xylol, Mesitylen, Chlorbenzol oder Dichlorbenzol, Trialkylamine, stickstoffhaltige Heterocyclen, N,N-disubstituierte aliphatische Carbonsäureamide, wie etwa Dimethylformamid, Diethylformamid, Dimethylacetamid oder Dimethylbutyramid, N-Alkyllactame, wie etwa N-Methylpyrrolidon, lineare und cyclische Ketone, wie etwa Methylethylketon, Cyclopentanon oder Cyclohexanon, cyclische Ether, wie etwa Tetrahydrofuran, oder Alkohole, wie etwa Methanol, Ethanol, Propanol, Isopropanol oder Butanol.

Desweiteren können auch Mischungen der vorgenannten Lösungsmittel Verwendung finden.

Geeignete Methoden zur Aufbringung der erfindungsgemäßen photoaktiven Schichten aus flüssiger Phase sind dem Fachmann bekannt. Vorteilhaft zeigt sich hier insbesondere die Prozessierung mittels Spin-Coating, da die Dicke der photoaktiven Schicht in einfacher Weise durch die Menge und/oder Konzentration der verwendeten Lösung sowie die Rotationsgeschwindigkeit und/oder Rotationsdauer gesteuert werden kann. Die Prozessierung der Lösung erfolgt in der Regel bei Raumtemperatur.

Vorzugsweise werden die Komponenten K1 und K2 aber aus der Gasphase, insbesondere durch Vakuumsublimation, abgeschieden. Da die Verbindungen der Formel la in der Regel durch Sublimation gereinigt werden können, lassen sich daraus bereits Startparameter für die Gasphasenabscheidung ableiten. Üblicherweise werden für die Abscheidung Temperaturen zwischen 100 und 200 °C angewendet, sie können aber auch, je nach Stabilität der Verbindungen der Komponenten K1 und K2 auch bis in einen Bereich von 300 bis 400 °C erhöht werden.

Im Rahmen der vorliegenden Erfindung werden auch Mischungen beansprucht, welche als Komponenten ein oder mehrere der eingangs gezeigten Verbindungen der allgemeinen Formel la der Komponente K1, auch unter Berücksichtigung der aufgeführten Bevorzugungen, und ein oder mehrere Verbindungen der Komponente K2, ebenfalls unter Berücksichtigung ihrer aufgeführten Bevorzugungen, enthalten.

Insbesondere zeichnen sich die erfindungsgemäßen Mischungen dadurch aus, dass die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen.

Nachfolgend wird die Erfindung anhand der nicht als Einschränkung des Erfindungsumfangs zu verstehenden Beispiele näher erläutert.

### Beispiele:

### I. Synthese von erfindungsgemäß zu verwendenden Verbindungen:

Verbindungen la-1 bis la-4 entsprechend der allgemeinen Formel la:

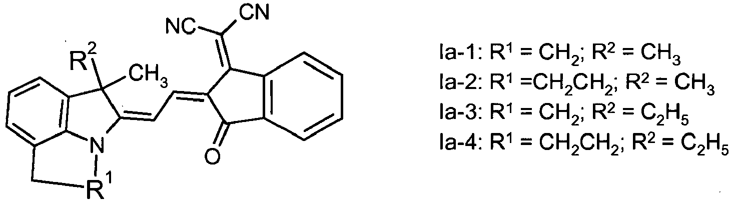

Allgemeines Syntheseschema:

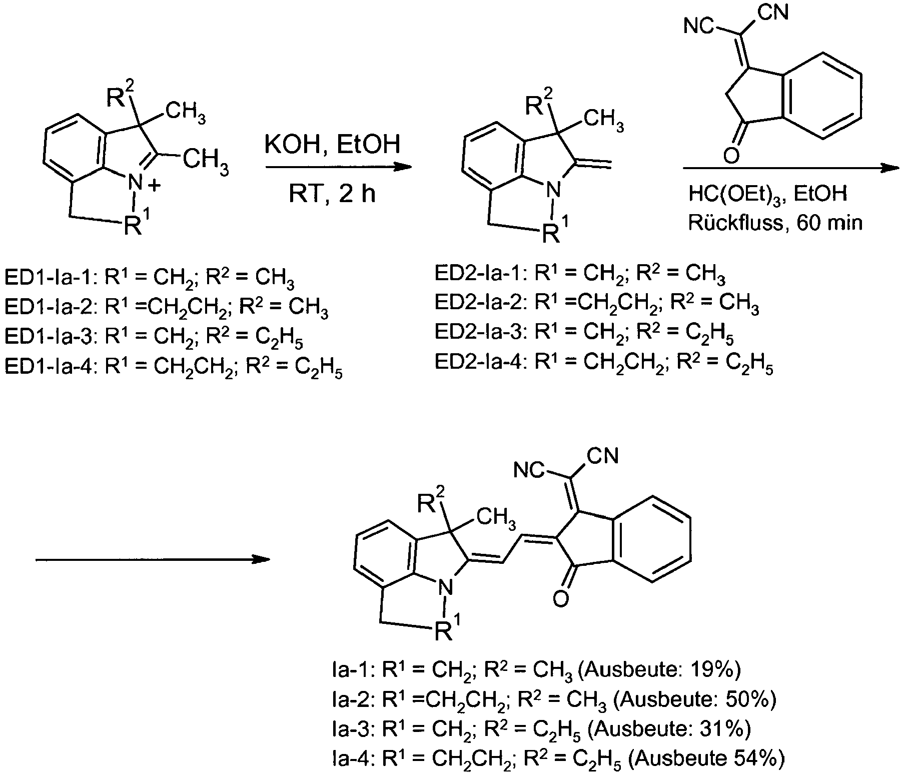

Allgemeine Vorschrift zur Herstellung der Verbindungen ED2-Ia-1 bis ED2-Ia-4:
1 Equivalent des entsprechenden Salzes ED1-Ia-1 bis ED1-Ia-4 in 15-20 Equivalenten trockenem Ethanol (EtOH) wurde mit 1,1 Equivalenten KOH versetzt. Die Lösung wurde 3 h bei Raumtemperatur gerührt, bevor das Lösungsmittel unter Vakuum entfernt wurde. Nach Zugabe von Wasser wurde mit Diethylether ausgeschüttelt. Nach erneutem Entfernen des Lösungsmittels unter Vakuum wurde ein Öl erhalten, welches direkt weiter umgesetzt wurde.

### Charakterisierung:

1,1-Dimethyl-2-methylen-1,2,4,5-tetrahydro-pyrrolo[3,2,1-*hi*]-indol (ED2-Ia-1) Ausbeute: 520 mg, 77%. ¹H NMR (CDCl₃, 400 MHz): δ = 6,93 (m, 1H), 6,87 (m,1 H), 6,63 (m, 1 H), 3,95 (d, ²*J* = 1,6 Hz, 1 H), 3,87 (d, ²*J* = 1,6 Hz, 1 H), 3,65 (m, 2H), 3,41 (m, 2H), 1,42 (s, 6H). HRMS (ESI): ber. für C₁₃H₁₆N [M+H]⁺: 186,1277, gef.: 186,1277.

1,1-Dimethyl-2-methylen-1,2,4,5-tetrahydro-pyrrolo[3,2,1-*hi*]-quinolin (ED2-Ia-2) Ausbeute: 4,33 g, 42%. ¹H NMR (CDCl₃, 400 MHz): δ = 6,94 (m, 1H), 6,87 (m,1H), 6,67 (m, 1 H), 3,81 (d, ²*J* = 1,6 Hz, 1 H), 3,79 (d, ²*J* = 1,6 Hz, 1 H), 3,40 (t, ³*J* = 5,8 Hz, 2H), 2,73 (m, 2H), 2,04 (m, 2H), 1,37 (s, 6H). HRMS (ESI): ber. für C₁₄H₁₈N [M+H]⁺: 200,1434, gef.: 200,1434.

1-Ethyl-1-methyl-2-methylen-1,2,4,5-tetrahydro-pyrrolo[3,2,1-*hi*]-indol (ED2-Ia-3) Ausbeute: 276 mg, 84%. ¹H NMR (CDCl₃, 400 MHz, TMS): δ = 6,91 (m, 1 H), 6,83 (m, 1 H), 6,62 (m, 1 H), 3,91 (d, ²*J* = 0,7 Hz, 1 H), 3,88 (d, ²*J* = 0,7 Hz, 1 H), 3,54 (m, 2H), 2,96 (t, *J* = 6,1 Hz, 2H), 1,78 (m, 2H), 1,36 (s, 3H), 0,76 (t, *J* = 7,3 Hz, 3H). HRMS (ESI): ber. für C₁₄H₁₈N [M+H]+: 200,1434, gef.: 200,1434.

1-Ethyl-1-methyl-2-methylen-1,2,4,5-tetrahydro-pyrrolo[3,2,1-*hi*]-quinolin (ED2-Ia-4) Ausbeute: 590 mg, 97%. ¹H NMR (CDCl₃, 400 MHz, TMS): δ = 6,87 (m, 1H), 6,81 (m, 1 H), 6,57 (m, 1 H), 3,83 (d, ²*J* = 0,7 Hz, 1 H), 3,72 (d, ²*J* = 0,7 Hz, 1 H), 3,32 (m, 2H), 2,65 (t, *J* = 6,1 Hz, 2H), 1,95 (m, 2H), 1,92 (m, 1 H), 1,57 (m, 1 H), 1,25 (s, 3H), 0,51 (t, *J* = 7,3 Hz, 3H). HRMS (ESI): ber. für C₁₅H₂₀N [M+H]⁺: 214,1590, gef.: 214,1590.

Allgemeine Vorschrift zur Herstellung der Verbindungen la-1 bis la-4:
1 Equivalent ED2-Ia-1 bis ED2-Ia-4, 1 Equivalent 2-(3-Oxo-indan-1-yliden)-malononitril und 1,5 Equivalente Orthoameisensäuretriethylester in 1mL/ Equivalent Ethanol wurden 1 h unter Rückfluss erhitzt. Nach Entfernen des Lösungsmittels wurde das Produkt durch Säulenchromatographie (CH₂Cl₂) und Umfällen aus CH₂Cl₂/*n*-Hexan aufgereinigt.

### Charakterisierung:

### 2-{2-[2-(1,1-Dimethyl-4,5-dihydro-1H-pyrrolo[3,2,1-hi]indol-2-yliden)-ethyliden]-3-oxo-indan-1-yliden}-malononitril (la-1)

Ausbeute: 200 mg, 19%, brauner Feststoff. Smp 277°C. ¹H NMR (CDCl₃, 400 MHz): δ = 8,55 (d, ³*J* = 14,0 Hz, 1 H), 8,34 (m, 1 H), 7,58-7,73 (m, 4H), 7,39 (m, 1 H), 7,31 (m, 1 H), 7,22 (t, ³*J* = 7,3 Hz, 1 H), 4,64 (m, 2H), 3,77 (t, ³*J* = 6,2 Hz, 2H), 1,65 (s, 6H). UV-vis (CH₂Cl₂): λₘₐₓ (*ε*) = 486 (20300), 586 (51100 M⁻¹ cm⁻¹). HRMS (ESI): ber. für C₂₆H₂₀N₃O [M+H]⁺: 390,1600, gef.: 390,1599.

### 2-{2-[2-(1,1-Dimethyl-5,6-dihydro-1H,4H-pyrrolo[3,2,1-ij]quinolin-2-yliden)-ethyliden]-3-oxo-indan-1-yliden}-malononitril (la-2)

Ausbeute: 1,4 g, 50%, brauner Feststoff. Smp 291°C. ¹H NMR (CDCl₃, 400 MHz): δ = 9,00 (d, ³*J* = 14,0 Hz, 1 H), 8,56 (m, 1 H), 7,92 (d, ³*J* = 13,8 Hz, 1 H), 7,70 (m, 1 H), 7,58 (m, 2H), 7,15 (m, 3H), 4,05 (br, 2H), 2,90 (t, ³*J* = 6,1 Hz, 2H), 2,25 (m, 2H), 1,79 (s, 6H). UV-vis (CH₂Cl₂): λₘₐₓ(*ε*) = 482 (21700), 578 (60300 M⁻¹ cm⁻¹). HRMS (ESI): ber. für C₂₇H₂₁N₃O [M]⁺: 403,1685, gef.: 403,1679.

### 2-{2-[2-(1-Ethyl-1-methyl-4,5-dihydro-1H-pyrrolo[3,2,1-hi]indol-2-yliden)-ethyliden]-3-oxo-indan-1-yliden}-malononitril (la-3)

Ausbeute: 170 mg, 31%, brauner Feststoff. Smp 230 °C. ¹H NMR (DMSO-d₆, 400 MHz): *δ* 8,56 (d, ³*J* = 14,1 Hz, 1 H), 8,34 (m, 1 H), 7,65 (m, 4H), 7,34 (m, 2H), 7,23 (m, 1 H), 4,67 (bs, 2H), 3,79 (m, 2H), 2,04 (m, 2H), 1,63 (s, 3H), 0,62 (t, ³*J* = 7,4 Hz, 3H). UV-vis (CH₂Cl₂): λₘₐₓ (*ε*) = 486 (17500), 588 (45000). HRMS (ESI): ber. für C₂₇H₂₁N₃O [M]⁺: 403,1685, gef.: 403,1679.

### 2-{2-[2-(1-Ethyl-1-methyl-5,6-dihydro-1H,4H-pyrrolo[3,2,1-ij]quinolin-2-yliden)-ethyliden]-3-oxo-indan-1-yliden}-malononitril (Ia-4)

Ausbeute: 200 mg, 54%, dunkelroter Feststoff. Smp 255°C. ¹H-NMR (CDCl₃, 400 MHz): δ = 8,96 (d, ³*J* = 13,9 Hz, 1 H), 8,54 (m, 1 H), 7,90 (d, ³*J* = 13,9 Hz, 1 H), 7,70 (m, 1 H), 7,57 (m, 2H), 7,14 (m, 3H), 4,05 (bs, 2H), 2,90 (t, ³*J* = 6,2 Hz, 2H), 2,40 (bs, 1 H), 2,22 (m, 3H), 1,78 (s, 3H), 0,53 (t, ³*J* = 7,4 H, 3H). UV-vis (CH₂Cl₂): λₘₐₓ(*ε*) = 481 (18900), 577 (50100 M⁻¹ cm⁻¹). HRMS (ESI): ber. für C₂₈H₂₃N₃O [M]⁺: 417,1814, gef.: 417,1834.

Verbindungen Ia-5 bis la-12 entsprechend der allgemeinen Formel Ia:

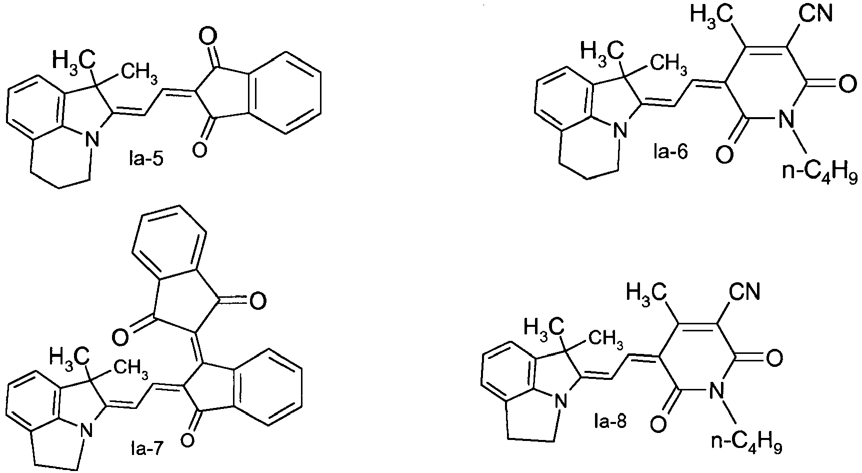

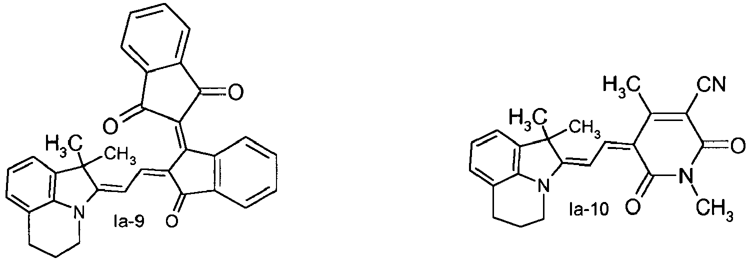

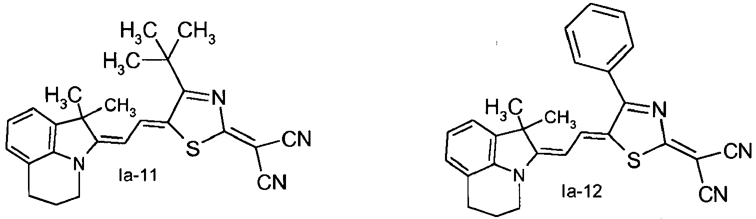

### Synthese:

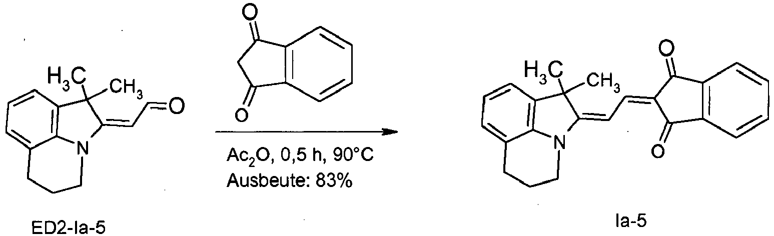

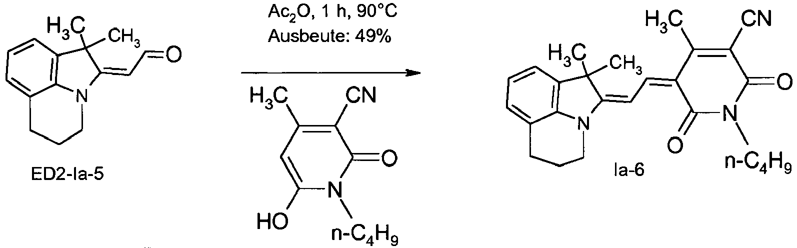

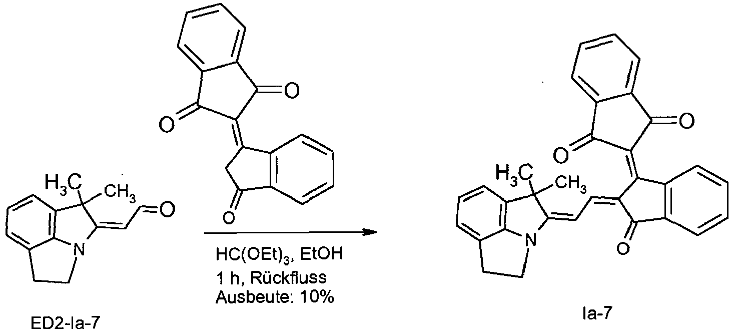

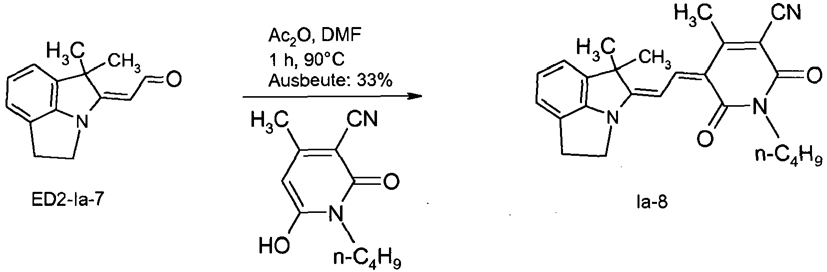

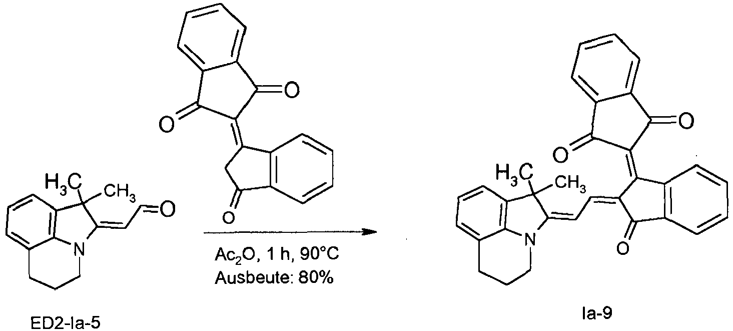

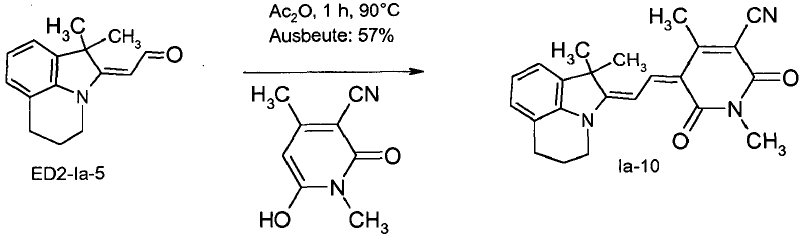

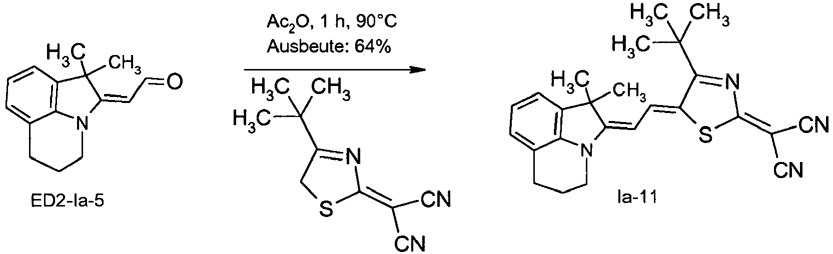

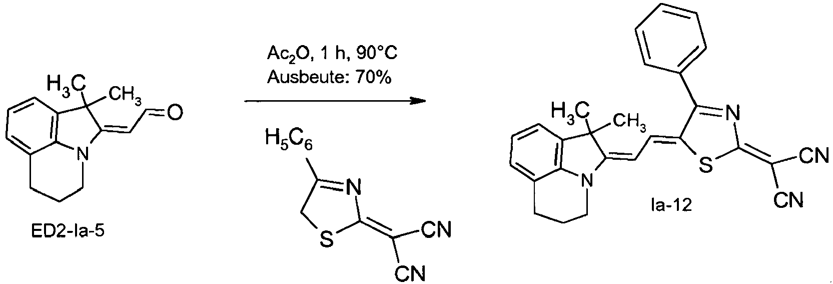

### Herstellung von 2-[2-(1,1-Dimethyl-5,6-dihydro-1H,4H-pyrrolo[3,2,1-ij]quinolin-2-yliden)-ethyliden]-indan-1,3-dion (la-5):

Eine Lösung aus 1,5 mL Acetanhydrid (Ac₂O), Verbindung ED2-Ia-5 (341 mg, 1,5 mmol) und Indandion 3 (219 mg, 1,5 mmol) wurde für 30 min auf 90°C erhitzt, bevor das Lösungsmittel unter Vakuum entfernt wurde. Nach der Säulenchromatographie (CH₂Cl₂) wurde der erhaltene Feststoff in CH₂Cl₂ gelöst und mit n-Hexan ausgefällt.

Ausbeute: 440 mg (1,24 mmol, 83%), violetter Feststoff. Smp 245-248°C. ¹H NMR (CDCl₃, 400 MHz): δ 8,08 (d, ³*J* = 14,2 Hz, 1 H), 7,77 (m, 2H), 7,60 (m, 2H), 7,37 (d, ³*J* = 14,2 Hz, 1H), 7,15 (m, 1H), 7,06 (m, 2H), 3,93 (bm, 2H), 2,86 (t, ³*J* = 6,1 Hz, 2H), 2,21 (m, 2H), 1,74 (s, 6H). UV/Vis (CH₂Cl₂): λₘₐₓ(*ε*): 500 (111200 M⁻¹ cm⁻¹). HRMS (ESI): ber. für C₂₄H₂₁NO₂ [M]⁺: 355,1572, gef.: 355,1567. Anal. ber. für C₂₄H₂₁NO₂: C, 81,10; H, 5,96; N, 3,94. Gef.: C, 80,75; H, 5,96; N, 4,10.

### Herstellung von 1-Butyl-5-[2-(1,1-dimethyl-5,6-dihydro-1H,4H-pyrrolo[3,2,1-ij]quinolin-2-yliden)-ethyliden]-4-methyl-2,6-dioxo-1,2,5,6-tetrahydro-pyridin-3-carbonitril (Ia-6):

Eine Lösung aus 1,5 mL Ac₂O, Verbindung ED2-Ia-5 (341 mg, 1,5 mmol) und dem Pyridonderivat (309 mg, 1,5 mmol) wurde für 30 min auf 90°C erhitzt, bevor das Lösungsmittel unter Vakuum entfernt wurde. Der Rückstand wurde in CH₂Cl₂ gelöst und mit n-Hexan ausgefällt, bevor eine Säulenchromatographie (CH₂Cl₂) durchgeführt wurde. Der erhaltene Feststoff wurde wieder in CH₂Cl₂ gelöst und mit n-Hexan ausgefällt. Ausbeute: 304 mg (0,73 mmol, 49%), roter Feststoff. Smp 247-249°C. ¹H NMR (CDCl₃, 400 MHz): δ 8,00 (d, ³*J* = 14,0 Hz, 1 H), 7,87 (d, ³*J* = 14,0 Hz, 1 H), 7,21 (m, 1 H), 7,16 (m, 2H), 4,03 (t, ³*J* = 5,9 Hz, 2H), 3,99 (t, ³*J* = 7,6 Hz, 2H), 2,90 (t, ³*J* = 6,1 Hz, 2H), 2,51 (s, 3H), 2,23 (m, 2H), 1,72 (s, 6H), 1,63 (m, 2H), 1,39 (m, 2H), 0,94 (t, ³*J* = 7,4 Hz, 3H). UV/Vis (CH₂Cl₂): *λ*ₘₐₓ(*ε*): 529 (133500 M⁻¹ cm⁻¹). HRMS (ESI): ber. für C₂₆H₃₀N₃O₂ [M+H]⁺: 416,2333, gef.: 416,2335.

### Herstellung von 2-[2-(1,1-Dimethyl-5,6-dihydro-1H,4H-pyrrolo[3,2,1-ij]quinolin-2-yliden)-ethyliden]-[1,2']biidenyliden-3,1',3'-trion(la-7):

Eine Lösung aus 7,0 mL EtOH, Verbindung ED2-Ia-7 (370 mg, 2,0 mmol), dem Indandionderivat (548 mg, 2,0 mmol) und Orthoameisensäuretriethylester (430 mg, 2,9 mmol) wurde 1 h unter Rückfluss erhitzt, bevor das Lösungsmittel unter Vakuum entfernt wurde. Nach der Säulenchromatographie (CH₂Cl₂) wurde der erhaltene Feststoff in CH₂Cl₂ gelöst und mit n-Hexan ausgefällt.

Ausbeute: 97 mg (0,21 mmol, 10%), dunkelgrüner Feststoff. Smp 269-272°C. ¹H NMR (CDCl₃, 400 MHz): δ 8,43 (m, 1 H), 8,13 (bm, 1 H), 7,84 (m, 2H), 7,65 (m, 4H), 7,48 (m, 2H), 7,17 (m, 3H), 4,46 (t, ³*J* = 6,9 Hz, 2H). 3,80 (t, ³*J* = 6,9 Hz, 2H), 1,65 (s, 6H). UV/Vis (CH₂Cl₂): λₘₐₓ (s): 669 (35400 M⁻¹ cm⁻¹). HRMS (ESI): ber. für C₃₂H₂₄NO₃ [M+H]+: 470,1751, gef.: 470,1751.

### Herstellung von 1-Butyl-5-[2-(1,1-dimethyl-4,5-dihydro-1H-pyrrolo[3,2,1-hi]indol-2-yliden)-ethyliden]-4-methyl-2,6-dioxo-1,2,5,6-tetrahydro-pyridine-3-carbonitril (Ia-8):

Eine Lösung aus 5,0 mL Ac₂O, Verbindung ED2-Ia-7 (926 mg, 5 mmol), dem Pyridonderivat (1,03 g, 5 mmol) und Dimethylformamid (DMF; 550 mg, 7,5 mL) wurde 1 h auf 90°C erhitzt, bevor das Lösungsmittel unter Vakuum entfernt wurde. Der Rückstand wurde in CH₂Cl₂ gelöst und mit n-Hexan ausgefällt, bevor eine Säulenchromatographie (CH₂Cl₂: MeOH = 98 : 2) durchgeführt wurde. Der erhaltene Feststoff wurde wieder in CH₂Cl₂ gelöst und mit n-Hexan ausgefällt.

Ausbeute: 666 mg (1,66 mmol, 33%), dunkelroter Feststoff. Smp 246-249°C. ¹H NMR (DMSO-d₆, 400 MHz): δ 7,78 (d, ³*J* = 14,5 Hz, 1 H), 7,57 (d, ³*J* = 14,5 Hz, 1 H), 7,39 (d, ³*J* = 7,3 Hz, 1 H), 7,31 (d, ³*J* = 6,9 Hz, 1 H), 7,21 (t, ³*J* = 7,3 Hz, 1 H), 4,73 (m, 2H), 3,84 (t, ³*J* = 7,4 Hz, 2H), 3,77 (t, ³*J* = 6,8 Hz, 2H), 2,47 (s, 3H), 1,58 (s, 6H), 1,47 (m, 2H), 1,27 (m, 2H), 0,90 (t, ³*J* = 7,4 Hz, 3H). UV/Vis (CH₂Cl₂): *λ*ₘₐₓ(*ε*): 537 (117400 M⁻¹ cm⁻¹). HRMS (ESI): ber. für C₂₅H₂₈N₃O₂ [M+H]⁺: 402,2176, gef.: 402,2176. Anal. ber. für C₂₅H₂₇N₃O₂: C, 74,79; H, 6,78; N, 10,47. Gef.: C, 74,36; H, 6,73; N, 10,58.

### Allgemeine Vorschrift zur Herstellung der Verbindungen la-9 bis la-12:

1 Equivalent des Akzeptormoleküls und ein Equivalent des Donormoleküls ED2-Ia-5 in 1mL/Äquivalent Ac₂O wurden 1 h auf 90°C erhitzt. Nachdem das Lösungsmittel entfernt worden war, wurde der ausgefallenen Feststoff mit n-Hexan und *iso*-Propanol gewaschen, wenn nötig mittels Säulenchromatographie aufgereinigt und das Produkt aus einem CH₂Cl₂/*n*-Hexan-Gemisch umgefällt.

### Charakterisierung:

### 2-[2-(1,1-Dimethyl-5,6-dihydro-1H,4H-pyrrolo[3,2,1-ij]quinolin-2-yliden)-ethyliden]-[1,2']biindenyliden-3,1',3'-trion (la-9)

Ausbeute: 339 mg (0,70 mmol, 80%), brauner Feststoff. ¹H NMR (CD₂Cl₂, 400 MHz): δ 8,51 (d, ³*J* = 14,6 Hz, 1 H), 8,42 (m, 1 H), 7,85 (m, 3H), 7,67 (m, 2H), 7,59 (m, 2H), 7,43 (m, 2H), 7,22 (m, 1H), 7,17 (m, 1H), 4,12 (m, 2H), 2,91 (m, 2H), 2,26 (m, 2H), 1,70 (s, 6H). UV-vis (CH₂Cl₂): *λ*ₘₐₓ(*ε*): 665 (46500 M⁻¹ cm⁻¹). HRMS (ESI): ber. für C₃₃H₂₆NO₃ [M+H]⁺: 484,1907, gef. 484,1908.

### 5-[2-(1,1-Dimethyl-5,6-dihydro-1H,4H-pyrrolo[3,2,1-ij]quinolin-2-yliden)-ethyliden]-1,4-dimethyl-2,6-dioxo-1,2,5,6-tetrahydro-pyridin-3-carbonitril (la-10)

Ausbeute: 186 mg (0,50 mmol, 57%), roter Feststoff. ¹H NMR (CD₂Cl₂, 400 MHz): δ 8,03 (m, 1 H), 7,91 (m, 1H), 7,23 (m, 1H), 7,16 (m, 2H), 4,03 (2H), 3,29 (s, 3H), 2,90 (m, 2H), 2,52 (s, 3H), 2,22 (m, 2H), 1,71 (s, 6H). UV-vis (CH₂Cl₂): *λ*ₘₐₓ (*ε*): 529 (131600 M⁻¹ cm⁻¹). HRMS (ESI): ber. für C₂₃H₂₄N₃O₂ [M+H]⁺: 374,1863, gef. 374,1861.

### 2-{4-tert-Butyl-5-[2-(1,1-dimethyl-5,6-dihydro-1H,4H-pyrrolo[3,2,1-ij]quinolin-2-yliden)-ethyliden]-5H-thiazol-2-yliden}-malononitril (Ia-11)

Laufmittel für die Säulenchromatographie: DCM mit 0,2% MeOH. Ausbeute: 235 mg (0,57 mmol, 64%), dunkelblauer Feststoff. ¹H NMR (CD₂Cl₂, 400 MHz): δ 8,29 (d, *³J* = 13,5 Hz, 1 H), 7,20 (m, 1H), 7,14 (m, 2H), 5,60 (d, *³J* = 13,6 Hz, 1H), 3,90 (m, 2H), 2,88 (m, 2H), 2,22 (m, 2H), 1,68 (s, 6H), 1,54 (s, 9H). UV-vis (CH₂Cl₂): *λ*ₘₐₓ(*ε*): 627 (146100 M⁻¹ cm⁻¹). HRMS (ESI): ber. für C₂₅H₂₆N₄S [M]⁺: 414,1878, gef. 414,1873.

### 2-{5-[2-(1,1-Dimethyl-5,6-dihydro-1H,4H-pyrrolo[3,2,1-ij]quinolin-2-yliden)-ethyliden]-4-phenyl-5H-thiazol-2-yliden}-malononitril (Ia-12)

Laufmittel für die Säulenchromatographie: DCM mit 0,3% MeOH.

Ausbeute: 267 mg (0,61 mmol, 70%), grünblauer Feststoff. ¹H NMR (CD₂Cl₂, 400 MHz): δ 7,99 (d, *³J* = 13,7 Hz, 1 H), 7,73 (m, 2H), 7,59 (m, 3H), 7,17 (m, 3H), 5,83 (d, *³J* = 13,1 Hz, 1H), 3,96 (m, 2H), 2,89 (m, 2H), 2,23 (m, 2H), 1,55 (s, 6H). UV-vis (CH₂Cl₂): *λ*ₘₐₓ (e): 635 (123200 M⁻¹ cm⁻¹). HRMS (ESI): ber. für C₂₇H₂₂N₄S [M]⁺: 434,1565, gef. 434,1559.

### II. Beispiele für Solarzellen:

Alle aufgeführten Solarzellen wurden gemäß den nachfolgenden Schritten hergestellt: Sublimation der Merocyanine:
Die eingangs aufgeführten Materialien wurden durch Zonensublimation gereinigt, wobei der Druck während der gesamten Sublimation unter 1 x10⁻⁵ mbar gehalten wurde. Die Ausbeuten der Sublimationsreinigung für jedes Material sind in Tabelle 2 gelistet.

### Materialien:

Die Merocyanine (im Folgenden auch als Mcy bezeichnet) wurden entweder wie aus der Synthese erhalten oder in nachgereinigtem Zustand, wie zuvor beschrieben, verwendet.
- NPD:: von der Fa. Alfa Aesar; einmal sublimiert
- C60:: von der Fa. Alfa Aesar; sublimierte Reinheit (+99.92%); ohne weitere Reinigung verwendet
- Bphen:: von der Fa. Alfa Aesar; ohne weitere Reinigung verwendet

### Vorbereitung des Substrats:

Das ITO wurde auf das Glassubstrat in einer Dicke von 140 nm aufgesputtert. Der spezifische Widerstand betrug 200 µΩcm und die mittlere Rauigkeit (RMS; roughness mean square) < 5 nm. Das Substrat wurde vor der Abscheidung der weiteren Schichten unter UV-Licht für 20 Minuten mit Ozon behandelt.

### Herstellung der Zellen:

Zellen vom Aufbau A) und B) wurden im Hochvakuum (Druck < 10⁻⁶ mbar) präpariert.

Die Zelle vom Aufbau A) (ITO/Merocyanin/C60/Bphen/Ag) wurde durch zeitlich aufeinander folgende Abscheidung des Merocyanins und C60 auf das ITO-Substrat hergestellt. Die Abscheidungsrate betrug für beide Schichten 0,1 nm/Sekunde. Die Verdampfungstemperaturen der Merocyanine sind in Tabelle 1 gelistet. C60 wurde bei 400°C abgeschieden. Nachdem die Bphen-Schicht aufgebracht worden war, wurde abschließend eine 100 nm dicke Ag-Schicht als Topelektrode aufgedampft. Die Zelle hatte eine Fläche von 0,031 cm².

Für die Herstellung der Zellen vom Aufbau B) (ITO/(Merocyanin:C60 - gewichtsmäßig 1:1)/C60/Bphen/Ag) wurden das Merocyanin und das C60 gemeinsam verdampft und auf dem ITO mit derselben Abscheidungsrate von 0,1 nm/Sekunde aufgebracht, so dass in der gemischten aktiven Schicht ein Massenverhältnis von 1:1 vorlag. Die Bphen- und Ag-Schicht waren identisch zu den entsprechend Schichten des Aufbaus A).

Die Daten einer Zelle mit BHJ-Schicht auf einer dotierten HTL (Schicht 22) sind in Tabelle 3 aufgeführt. NPD und F₄-TCNQ wurden als HTL und Dotierstoff in einem Massen-Verhältnis von 20:1 aufgedampft. Die HTL-Schicht verbesserte die Spannung V_{oc} bei Stromlosigkeit (oc: open circuit) und lieferte höhere Effizienzen.

### Messungen:

Verwendet wurde ein AM 1.5 Simulator der Fa. Solar Light Co. Inc. mit Xenonlampe (Modell 16S-150 V3). Der UV-Bereich unter 415 nm wurde ausgefiltert und die Strom-Spannungsmessungen wurden bei Umgebungsbedingungen durchgeführt. Die Intensität des Solarsimulators wurde mit einer monokristallinen FZ Solarzelle (Fraunhofer ISE) kalibriert und der Abweichungsfaktor zu nahezu 1,0 bestimmt.

### Resultate der Solarzellen:

**Tabelle 1. Ergebnisse mit den eingangs gezeigten Merocyaninen im Aufbau A). Die Verdampfungstemperaturen Tᵥ sind ebenfalls aufgeführt.**

| Mcy (ID) | Tᵥ (°C) | Mcy Dicke (nm) | C60 Dicke (nm) | Voc (mV) | Jsc (mA/cm²) | FF (%) | Effizienz (%) |
|---|---|---|---|---|---|---|---|
| 606 | 180 | 10 | 40 | 460 | 7,3 | 62 | 2,0 |
| 716 | 175 | 10 | 40 | 420 | 7,0 | 67 | 1,9 |

**Tabelle 2. Ergebnisse mit den eingangs gezeigten Merocyaninen im Aufbau B). Die Verdampfungstemperaturen Tᵥ sind ebenfalls aufgeführt.**

| ID | BHJ Dicke (nm) | C60 Dicke (nm) | Voc (mV) | Jsc (mA/cm²) | FF (%) | Effizienz (%) |
|---|---|---|---|---|---|---|
| 606 | 30 | 20 | 580 | 10,8 | 46 | 2,8 |
| 716 | 30 | 20 | 520 | 11,5 | 45 | 2,6 |

## Patentansprüche

1. Verwendung von Mischungen, enthaltend als Komponenten
K1) eine oder mehrere Verbindungen der allgemeinen Formel 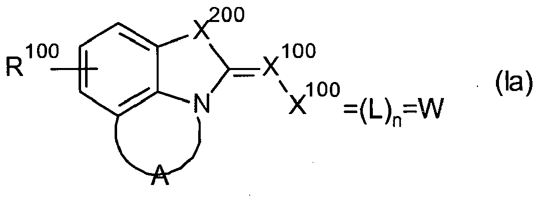 als Elektronendonor bzw. Elektronenakzeptor, worin bedeuten
A eine Brücke bestehend aus zwei oder drei sp³-hybridisierten Kohlenstoffatomen, in welcher jedes Kohlenstoffatom zusätzlich noch mit je einem Substituenten R¹⁰¹ substituiert oder welche benzanelliert sein kann,
W C(CN)₂
L ein zweiwertiger, gegebenenfalls ein- oder mehrfach anellierter Carbo- oder Heterocyclus,
n 1,
X¹⁰⁰ CH
X²⁰⁰ C(R¹¹¹)₂,
R¹⁰⁰ H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl, OR¹¹⁰, SR¹¹⁰, Hetaryl, Halogen, NO₂ oder CN,
R¹⁰¹ Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl oder Hetaryl,
R¹¹⁰ H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl oder Aryl,
R¹¹¹ H, Alkyl, C₁-C₆-Alkylen-COO-Alkyl, C₁-C₆-Alkylen-O-CO-Alkyl, C₁-C₆- Alkylen-O-CO-O-Alkyl, Cylcloalkyl, Arylalkyl, Aryl oder Hetaryl,
wobei die Kohlenstoffketten der Alkyl- und Cylcloalkyl-Reste durch ein oder zwei nicht benachbarte Sauerstoffatome unterbrochen sein können, und die zuvor genannten Variablen, sofern sie mehr als einmal auftreten, gleich oder voneinander verschieden sein können
und
K2) eine oder mehrere Verbindungen, welche gegenüber Komponente K1) entsprechend als Elektronenakzeptor bzw. Elektronendonor wirken,
zur Herstellung von photoaktiven Schichten für organische Solarzellen und organische Photodetektoren.

2. Verwendung nach Anspruch 1, **dadurch gekennzeichnet, dass** in der Formel la von Anspruch 1 L eine Gruppierung 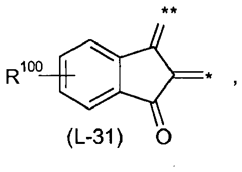 bedeutet,
worin * und ** die Anbindung an die Einheit X¹⁰⁰ bzw. W bezeichnet, die Kohlenstoffketten der Alkyl- und Cycloalkyl-Reste durch ein oder zwei nicht benachbarte Sauerstoffatome unterbrochen sein können, und
die übrigen Variablen die Bedeutung wie in Anspruch 1 besitzen, und die in Anspruch 1 genannten Variablen, sofern sie mehr als einmal auftreten, gleich oder voneinander verschieden sein können.

3. Verwendung nach Anspruch 1 oder 2, **dadurch gekennzeichnet, dass** es sich bei Komponente K2 um eine oder mehrere Verbindungen ausgewählt aus der Gruppe
a) Fullerene und Fullerenderivate,
b) polycyclische aromatische Kohlenwasserstoffe und deren Derivate, insbesondere Naphthalin und dessen Derivate, Rylene, insbesondere Perylen, Terrylen und Quaterrylen, und deren Derivate, Azene, insbesondere Anthrazen, Tetrazen, insbesondere Rubren, Pentazen und deren Derivate, Pyren und dessen Derivate, Coronen und Hexabenzocoronen und deren Derivate,
c) Chinone, Chinondimethane und Chinondiimine und deren Derivate,
d) Phthalocyanine und Subphthalocyanine und deren Derivate,
e) Porphyrine, Tetraazaporphyrine und Tetrabenzoporphyrine und deren Derivate,
f) Thiophene, oligo-Thiophene, kondensierte/anellierte Thiophene, wie Thienothiophen und Bithienothiophen, und deren Derivate,
g) Thiadiazole und deren Derivate,
h) Carbazole und Triarylamine und deren Derivate,
i) Indanthrone, Violanthrone und Flavanthone und deren Derivate,
j) Fulvalene, Tetrathiafulvalene und Tetraselenafulvalene und deren Derivate und
k) Diketopyrrolopyrrole und deren Derivate
handelt.

4. Verwendung nach Anspruch 1 oder 2, **dadurch gekennzeichnet, dass** es sich bei Komponente K2 um ein oder mehrere Fullerene und/oder Fulleren-Derivate handelt.

5. Verwendung nach einem Anspruch 1 oder 2, **dadurch gekennzeichnet, dass** es sich bei Komponente K2 um ein oder mehrere Fullerene handelt.

6. Verwendung nach Anspruch 1 oder 2, **dadurch gekennzeichnet, dass** es sich bei Komponente K2 um ein C60-Fulleren handelt.

7. Verwendung nach einem oder mehreren der Ansprüche 1 bis 6, **dadurch gekennzeichnet, dass** die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen.

8. Verfahren zur Herstellung von photoaktiven Schichten, **dadurch gekennzeichnet, dass** eine oder mehrere Verbindungen der allgemeinen Formel la der Komponente K1 gemäß Anspruch 1 oder 2 und eine oder mehrere Verbindungen der Komponente K2 gemäß Anspruch 3, 4, 5 oder 6 gleichzeitig, nacheinander oder in alternierender Abfolge durch Vakuumsublimation auf einem Substrat abgeschieden werden.

9. Verfahren nach Anspruch 8, **dadurch gekennzeichnet, dass** die Komponenten K1 und K2 nach ihrer Abscheidung in einem Verhältnis gemäß Anspruch 7 auf dem Substrat vorliegen.

10. Organische Solarzellen und organische Photodetektoren, enthaltend photoaktive Schichten, welche unter Verwendung von Mischungen gemäß einem oder mehreren der Ansprüche 1 bis 6 hergestellt worden sind oder welche gemäß einem Verfahren nach Anspruch 8 oder 9 erhältlich sind.

11. Mischungen, enthaltend als Komponenten eine oder mehrere Verbindungen der allgemeinen Formel la der Komponente K1 gemäß Anspruch 1 oder 2 und ein oder mehrere Verbindungen der Komponente K2 gemäß Anspruch 3, 4, 5 oder 6.

12. Mischungen nach Anspruch 11, **dadurch gekennzeichnet, dass** die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen.

## Claims

1. The use of mixtures comprising, as components,
K1) one or more compounds of the general formula 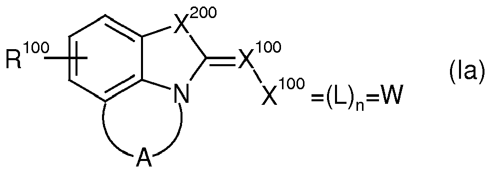 as an electron donor or electron acceptor, in which
A is a bridge consisting of two or three sp³-hybridized carbon atoms, in which each carbon atom may additionally be substituted by one R¹⁰¹ substituent each and which may additionally be benzofused,
W is C(CN)₂
L is a divalent, optionally singly or multiply fused carbo- or heterocycle,
n is 1,
X¹⁰⁰ is CH
X²⁰⁰ is C(R¹¹¹)₂,
R¹⁰⁰ is H, alkyl, C₁-C₆-alkylene-COO-alkyl, C₁-C₆-alkylene-O-CO-alkyl, C₁-C₆- alkylene-O-CO-O-alkyl, cycloalkyl, arylalkyl, aryl, OR¹¹⁰, SR¹¹⁰, hetaryl, halogen, NO₂ or CN,
R¹⁰¹ is alkyl, C₁-C₆,-alkylene-COO-alkyl, C₁-C₆-alkylene-O-CO-alkyl, C₁-C₆- alkylene-O-CO-O-alkyl, cycloalkyl, arylalkyl, aryl or hetaryl,
R¹¹⁰ is H, alkyl, C₁-C₆-alkylene-COO-alkyl, C₁-C₆-alkylene-O-CO-alkyl, C₁-C₆- alkylene-O-CO-O-alkyl, cycloalkyl, arylalkyl or aryl,
R¹¹¹ is H, alkyl, C₁-C₆-alkylene-COO-alkyl, C₁-C₆-alkylene-O-CO-alkyl, C₁-C₆- alkylene-O-CO-O-alkyl, cycloalkyl, arylalkyl, aryl or hetaryl,
where the carbon chains of the alkyl and cycloalkyl radicals may be interrupted by one or two nonadjacent oxygen atoms and the aforementioned variables, where they occur more than once, may be the same or different,
and
K2) one or more compounds which, with respect to component K1), act correspondingly as an electron acceptor or electron donor
for producing photoactive layers for organic solar cells and organic photodetectors.

2. The use according to Claim 1, wherein L in the formula Ia of Claim 1 is a moiety 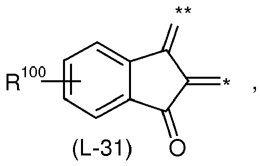 where * and ** denote the attachment to the X¹⁰⁰ or W unit, the carbon chains of the alkyl and cycloalkyl radicals may be interrupted by one or two nonadjacent oxygen atoms, and
the remaining variables are each as defined in claim 1, and the variables mentioned in claim 1, where they occur more than once, may be the same or different.

3. The use according to Claim 1 or 2, wherein component K2 comprises one or more compounds selected from the group of
a) fullerenes and fullerene derivatives,
b) polycyclic aromatic hydrocarbons and derivatives thereof, especially naphthalene and derivatives thereof, rylenes, especially perylene, terrylene and quaterrylene, and derivatives thereof, acenes, especially anthracene, tetracene, especially rubrene, pentacene and derivatives thereof, pyrene and derivatives thereof, coronene and hexabenzocoronene and derivatives thereof,
c) quinones, quinodimethanes and quinonediimines and derivatives thereof,
d) phthalocyanines and subphthalocyanines and derivatives thereof,
e) porphyrins, tetraazaporphyrins and tetrabenzoporphyrins and derivatives thereof,
f) thiophenes, oligothiophenes, fused thiophenes such as thienothiophene and bithienothiophene, and derivatives thereof,
g) thiadiazoles and derivatives thereof,
h) carbazoles and triarylamines and derivatives thereof,
i) indanthrones, violanthrones and flavanthones and derivatives thereof,
j) fulvalenes, tetrathiafulvalenes and tetraselenafulvalenes and derivatives thereof, and
k) diketopyrrolopyrroles and derivatives thereof.

4. The use according to Claim 1 or 2, wherein component K2 comprises one or more fullerenes and/or fullerene derivatives.

5. The use according to Claim 1 or 2, wherein component K2 comprises one or more fullerenes.

6. The use according to claim 1 or 2, wherein component K2 comprises a C60- fullerene.

7. The use according to one or more of Claims 1 to 6, wherein component K1 is present in a proportion of from 10 to 90% by mass, especially from 20 to 80% by mass, and component K2 in a proportion of from 90 to 10% by mass, especially from 80 to 20% by mass, where the proportions of components K1 and K2, based in each case on the total mass of components K1 and K2, add up to 100% by mass.

8. A process for producing photoactive layers, wherein one or more compounds of the general formula Ia of component K1 according to claim 1 or 2 and one or more compounds of component K2 according to claim 3, 4, 5 or 6 are deposited on a substrate successively, simultaneously or in alternating sequence by vacuum sublimation.

9. The process according to Claim 8, wherein components K1 and K2, after they have been deposited, are present on the substrate in a ratio according to claim 7.

10. An organic solar cell or organic photodetector, comprising photoactive layers which have been produced using mixtures according to one or more of Claims 1 to 6 or which are obtainable by a process according to Claim 8 or 9.

11. A mixture comprising, as components, one or more compounds of the general formula Ia of component K1 according to Claim 1 or 2 and one or more compounds of component K2 according to Claim 3, 4, 5 or 6.

12. The mixture according to Claim 11, wherein component K1 is present in a proportion of from 10 to 90% by mass, especially from 20 to 80% by mass, and component K2 in a proportion of from 90 to 10% by mass, especially from 80 to 20% by mass, where the proportions of components K1 and K2, based in each case on the total mass of components K1 and K2, add up to 100% by mass.

## Revendications

1. Utilisation de mélanges contenant en tant que composants
K1) un ou plusieurs composés de formule générale 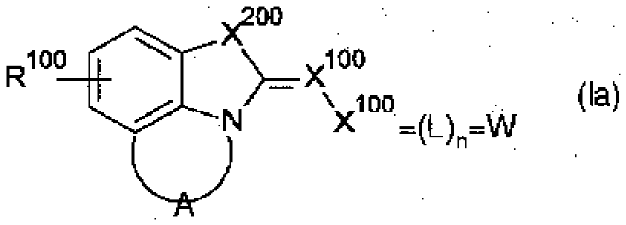 en tant que donneur d'électrons ou respectivement accepteur d'électrons, formule dans laquelle
A représente un pont constitué de deux ou trois atomes de carbone hybridés sp³, dans lequel chaque atome de carbone peut en outre être encore substitué par chaque fois un substituant R¹⁰¹, ou qui peut être soudé à un noyau benzénique,
W représente C(CN)₂,
L représente un cycle carbocyclique ou hétérocyclique divalent, éventuellement une ou plusieurs fois condensé,
n est égal à 1,
X¹⁰⁰ représente CH,
X²⁰⁰ représente C(R¹¹¹)₂,
R¹⁰⁰ représente H, un groupe alkyle, alkylène(C₁-C₆)-COO-alkyle, alkylène(C₁-C₆)-O-CO-alkyle, alkylène(C₁-C₆)-O-CO-O-alkyle, cycloalkyle, arylalkyle, aryle, OR¹¹⁰, SR¹¹⁰, hétéroaryle, un atome d'halogène, NO₂ ou CN,
R¹⁰¹ représente un groupe alkyle, alkylène(C₁-C₆)-COO-alkyle, alkylène(C₁-C₆)-O-CO-alkyle, alkylène(C₁-C₆)-O-CO-O-alkyle, cycloalkyle, arylalkyle, aryle ou hétéroaryle,
R¹¹⁰ représente H, un groupe alkyle, alkylène(C₁-C₆)-COO-alkyle, alkylène(C₁-C₆)-O-CO-alkyle, alkylène(C₁-C₆)-O-CO-O-alkyle, cycloalkyle, arylalkyle, aryle ou aryle,
R¹¹¹ représente H, un groupe alkyle, alkylène(C₁-C₆)-COO-alkyle, alkylène(C₁-C₆)-O-CO-alkyle, alkylène(C₁-C₆)-O-CO-O-alkyle, cycloalkyle, arylalkyle, aryle ou hétéroaryle,
les chaînes carbonées des radicaux alkyle et cycloalkyle pouvant être interrompues par un ou deux atomes d'oxygène non contigus, et les variables précitées, lorsqu'elles apparaissent plus d'une fois, pouvant être identiques ou différentes les unes des autres
et
K2) un ou plusieurs composés qui agissent en tant qu'accepteur d'électrons ou respectivement donneur d'électrons vis-à-vis du composant K1),
pour la production de couches photoactives pour des cellules solaires organiques et des photodétecteurs organiques.

2. Utilisation selon la revendication 1, **caractérisée en ce que** dans la formule la de la revendication 1 L représente un groupement 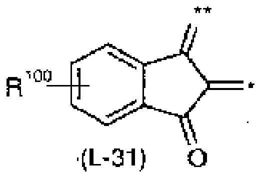 dans lequel * et ** désignent l'attachement à l'unité X¹⁰⁰ ou respectivement W, les chaînes carbonées des radicaux alkyle et cycloalkyle peuvent être interrompues par un ou deux atomes d'oxygène non contigus, et
les autres variables ont la même signification que dans la revendication 1, et les variables indiquées dans la revendication 1, lorsqu'elles apparaissent plus d'une fois, peuvent être identiques ou différentes les unes des autres.

3. Utilisation selon la revendication 1 ou 2, **caractérisée en ce que** pour ce qui est du composant K2 il s'agit d'un ou de plusieurs composés choisis dans le groupe constitué par
a) des fullerènes et dérivés de fullerènes,
b) des hydrocarbures aromatiques polycycliques et leurs dérivés, en particulier le naphtalène et ses dérivés, des Rylènes, en particulier le pérylène, le terrylène et le quaterrylène, et leurs dérivés, des azènes, en particulier l'anthracène, le tétrazène, en particulier le rubrène, le pentazène et leurs dérivés, le pyrène et ses dérivés, le coronène et l'hexabenzocoronène et leurs dérivés ;
c) des quinones, quinonediméthanes et quinonediimines et leurs dérivés,
d) des phtalocyanines et subphtalocyanines et leurs dérivés,
e) des porphyrines, tétraazaporphyrines et tétrabenzoporphyrines et leurs dérivés,
f) des thiophènes, oligothiophènes, thiophènes condensés/soudés, tels que le thiénothiophène et le bithiénothiophène, et leurs dérivés,
g) des thiadiazoles et leurs dérivés,
h) des carbazoles et triarylamines et leurs dérivés,
i) des indanthrones, violanthrones et leurs dérivés,
j) des fulvalènes, tétrathiafulvalènes et tétasélénafulvalènes et leurs dérivés et
k) des dicétopyrrolopyrroles et leurs dérivés.

4. Utilisation selon la revendication 1 ou 2, **caractérisée en ce que** pour ce qui est du composant K2 il s'agit d'un ou de plusieurs fullerènes et/ou dérivés de fullerènes.

5. Utilisation selon la revendication 1 ou 2, **caractérisée en ce que** pour ce qui est du composant K2 il s'agit d'un ou de plusieurs fullerènes.

6. Utilisation selon la revendication 1 ou 2, **caractérisée en ce que** pour ce qui est du composant K2 il s'agit d'un fullerène en C₆₀.

7. Utilisation selon une ou plusieurs des revendications 1 à 6, **caractérisée en ce que** le composant K1 est présent en une proportion de 10 à 90 % en masse, en particulier de 20 à 80 % en masse, et le composant K2 est présent en une proportion de 90 à 10 % en masse, en particulier de 80 à 20 % en masse, les proportions des composants K1 e K2 se complétant chaque fois à 100 % en masse par rapport à la masse totale des composants K1 et K2.

8. Procédé pour la production de couches photoactives, **caractérisé en ce qu'**on dépose sur un substrat, par sublimation sous vide, simultanément, successivement ou en alternance un ou plusieurs composés de formule générale Ia du composant K1 selon la revendication 1 ou 2 et un ou plusieurs composés du composant K2 selon la revendication 3, 4, 5 ou 6.

9. Procédé selon la revendication 8, **caractérisé en ce qu'**après leur dépôt les composants K1 et K2 sont présents sur le substrat en un rapport selon la revendication 7.

10. Cellules solaires organiques et photodétecteurs organiques, contenant des couches photoactives qui ont été produites avec utilisation de mélanges selon une ou plusieurs des revendications 1 à 6 ou qui peuvent être obtenues conformément à un procédé selon la revendication 8 ou 9.

11. Mélanges, contenant en tant que composants un ou plusieurs composés de formule générale la du composant K1 selon la revendication 1 ou 2 et un ou plusieurs composés du composant K2 selon la revendication 3, 4, 5 ou 6.

12. Mélanges selon la revendication 11, **caractérisés en ce que** le composant K1 est présent en une proportion de 10 à 90 % en masse, en particulier de 20 à 80 % en masse, et le composant K2 est présent en une proportion de 90 à 10 % en masse, en particulier de 80 à 20 % en masse, les proportions des composants K1 e K2 se complétant chaque fois à 100 % en masse par rapport à la masse totale des composants K1 et K2.
